# EUROPEAN PATENT APPLICATION

(11) **EP 4 592 794 A1**
(43) Date of publication of application: **30.07.2025**
(21) Application number: 25152601.8
(22) Date of filing: 17.01.2025
(51) Int. Cl.: G06F 1/16, G06F 3/044, H04M 1/02

(54) **ELECTRONIC DEVICE COMPRISING A DISPLAY PANEL AND AN INPUT SENSOR**

(30) Priority: 24.01.2024 KR 20240010659
(71) Applicant: Samsung Display Co., Ltd., Yongin-si Gyeonggi-do (KR)
(72) Inventor: Lee, Seungchan, Yongin-si, Gyeonggi-Do (KR); Jun, Sanghyun, Yongin-si, Gyeonggi-Do (KR); Han, Jeongyun, Hwaseong-si, Gyeonggi-Do (KR)
(74) Representative: Gulde & Partner

(57) **Abstract**

An electronic device includes: a display panel including pixels and an encapsulation layer covering the pixels; and an input sensor on the display panel, wherein the input sensor includes: a first sensing insulation layer directly on the encapsulation layer; a first conductive pattern layer on the first sensing insulation layer; a second sensing insulation layer on the first sensing insulation layer and covering the first conductive pattern layer; a second conductive pattern layer on the second sensing insulation layer; a third sensing insulation layer on the second sensing insulation layer and covering the second conductive pattern layer; a third conductive pattern layer on the third sensing insulation layer; and a fourth sensing insulation layer on the third sensing insulation layer and covering the third conductive pattern layer, and wherein the first conductive pattern layer and the second conductive pattern layer receive the same voltage.

## Description

### CROSS-REFERENCE TO RELATED APPLICATION

The present application claims priority to and the benefit of Korean Patent Application No. 10-2024-0010659, filed on January 24, 2024, in the Korean Intellectual Property Office, the entire disclosure of which is incorporated herein by reference.

### BACKGROUND

### 1. Field

Aspects of some embodiments of the present disclosure described herein relate to an electronic device.

### 2. Description of the Related Art

Various electronic devices used in multimedia devices, such as mobile phones, tablet computers, car navigation units, game machines, and the like, are being developed. Such electronic devices may include a keyboard or a mouse as an input device. In addition, such electronic devices may include an input sensor as an input device.

The input sensor may sense a user input in a capacitive type, or may sense a user input in a self-cap type. The input sensor may sense an input of a stylus pen using an electromagnetic induction method.

The above information disclosed in this Background section is only for enhancement of understanding of the background and therefore the information discussed in this Background section does not necessarily constitute prior art.

### SUMMARY

Aspects of some embodiments of the present disclosure described herein relate to an electronic device, and for example, relate to an electronic device including an input sensor.

Aspects of some embodiments of the present disclosure include an electronic device with relatively improved input sensor efficiency and relatively improved display quality.

According to some embodiments, an electronic device includes a display panel and an input sensor on the display panel, and the display panel includes pixels and an encapsulation layer that covers the pixels. According to some embodiments, the input sensor includes a first sensing insulation layer directly on the encapsulation layer, a first conductive pattern layer on the first sensing insulation layer, a second sensing insulation layer that is on the first sensing insulation layer and that covers the first conductive pattern layer, a second conductive pattern layer on the second sensing insulation layer, a third sensing insulation layer that is on the second sensing insulation layer and that covers the second conductive pattern layer, a third conductive pattern layer on the third sensing insulation layer, and a fourth sensing insulation layer that is on the third sensing insulation layer and that covers the third conductive pattern layer. According to some embodiments, the first conductive pattern layer and the second conductive pattern layer receive the same voltage.

According to some embodiments, the first sensing insulation layer and the second sensing insulation layer may include a silicon-based inorganic material, and the third sensing insulation layer and the fourth sensing insulation layer may include an organic material.

According to some embodiments, the second conductive pattern layer may be connected with the first conductive pattern layer through contact holes defined in the second sensing insulation layer.

According to some embodiments, each of the first conductive pattern layer, the second conductive pattern layer, and the third conductive pattern layer may have a thickness of 100 nm to 1000 nm.

According to some embodiments, the input sensor may include first sensing patterns included in the third conductive pattern layer and second detection electrodes spaced apart from the first sensing patterns, and the second conductive pattern layer may include upper bridge patterns that connect the first sensing patterns spaced apart from each other through contact holes defined in the third sensing insulation layer.

According to some embodiments, the first conductive pattern layer may include lower bridge patterns connected with the upper bridge patterns through contact holes defined in the second sensing insulation layer, and the upper bridge patterns and the lower bridge patterns may have the same shape in a plan view.

According to some embodiments, the third conductive pattern layer may be implemented with a plurality of mesh lines that cross each other and define mesh openings.

According to some embodiments, the input sensor may sense an external input using a capacitance method.

According to some embodiments, the input sensor may include a first group of electrodes that sense an external input using a capacitance method and a second group of electrodes that sense an external input using an electromagnetic induction method.

According to some embodiments, the first group of electrodes may include a first-first detection electrode including a first-first sensing electrode and a first-second sensing electrode spaced part from each other with a first space therebetween in a first direction and a first-second detection electrode that is insulated from the first-first detection electrode and that includes a second-first sensing electrode and a second-second sensing electrode spaced apart from each other with a second space therebetween in a second direction crossing the first direction.

According to some embodiments, the second group of electrodes may include a second-first detection electrode that is in the first space and that extends in the second direction and a second-second detection electrode that is in the second space and that extends in the first direction.

According to some embodiments, each of the first-first sensing electrode and the first-second sensing electrode may include first sensing patterns spaced apart from each other in the second direction and first upper bridge patterns, each of which connects first sensing patterns adjacent to each other in the second direction. According to some embodiments, the second-first detection electrode may include second sensing patterns spaced apart from each other in the second direction and second upper bridge patterns, each of which connects second sensing patterns adjacent to each other in the second direction. According to some embodiments, a portion of each of the first upper bridge patterns and the second upper bridge patterns may overlap the first-second detection electrode and the second-second detection electrode in a plan view.

According to some embodiments, the third conductive pattern layer may include the first sensing patterns, the second sensing patterns, the first-second detection electrode, and the second-second detection electrode. According to some embodiments, the second conductive pattern layer may include the first upper bridge patterns and the second upper bridge patterns. According to some embodiments, the first sensing patterns may be connected with the first upper bridge patterns through first contact holes defined in the third sensing insulation layer, and the second sensing patterns may be connected with the second upper bridge patterns through second contact holes defined in the third sensing insulation layer.

According to some embodiments, the first conductive pattern layer may further include first lower bridge patterns connected with the first upper bridge patterns through third contact holes defined in the second sensing insulation layer and second lower bridge patterns connected with the second upper bridge patterns through fourth contact holes defined in the second sensing insulation layer. According to some embodiments, the first lower bridge patterns and the first upper bridge patterns may have the same shape in a plan view, and the second lower bridge patterns and the second upper bridge patterns may have the same shape in the plan view.

According to some embodiments, the input sensor may further include a fourth conductive pattern layer on the fourth sensing insulation layer and a fifth sensing insulation layer that is on the fourth sensing insulation layer and that covers the fourth conductive pattern layer, and the third conductive pattern layer and the fourth conductive pattern layer may receive the same voltage.

According to some embodiments, the first sensing insulation layer, the second sensing insulation layer, and the fourth sensing insulation layer may include a silicon-based inorganic material, and the third sensing insulation layer and the fifth sensing insulation layer may include an organic material.

According to some embodiments, the fourth conductive pattern layer may be connected with the third conductive pattern layer through contact holes defined in the fourth sensing insulation layer.

According to some embodiments, dummy contact holes spaced apart from the third conductive pattern layer may be defined in the fourth sensing insulation layer, and the sum of areas of the dummy contact holes may be greater than or equal to 0.1% of an area of the fourth sensing insulation layer.

According to some embodiments, each of the first conductive pattern layer, the second conductive pattern layer, and the third conductive pattern layer may include a first layer, a second layer, and a third layer sequentially stacked one above another. According to some embodiments, the first layer and the third layer may include titanium, and the second layer may include aluminum.

According to some embodiments, a first connecting opening may be defined in the second sensing insulation layer to expose a portion of the first conductive pattern layer, and a second connecting opening may be defined in the third sensing insulation layer to expose a portion of the second conductive pattern layer and the portion of the first conductive pattern layer and overlap the first connecting opening. According to some embodiments, the input sensor may further include a connecting pattern, and within the second connecting opening, the connecting pattern may make contact with the portion of the second conductive pattern layer and the portion of the first conductive pattern layer. According to some embodiments, the connecting pattern may include the same material as the third conductive pattern layer.

According to some embodiments, an electronic device includes a display module including a display panel and an input sensor on the display panel, a window on the display module, an electronic module under the display module, and a housing that is coupled with the window and in which the display module and the electronic module are accommodated, and the display panel includes pixels and an encapsulation layer that covers the pixels. According to some embodiments, the input sensor includes a first sensing insulation layer directly on the encapsulation layer, a first conductive pattern layer on the first sensing insulation layer, a second sensing insulation layer that is on the first sensing insulation layer and that covers the first conductive pattern layer, a second conductive pattern layer on the second sensing insulation layer, a third sensing insulation layer that is on the second sensing insulation layer and that covers the second conductive pattern layer, and a third conductive pattern layer on the third sensing insulation layer. According to some embodiments, the first conductive pattern layer and the second conductive pattern layer receive the same voltage.

According to some embodiments, the first sensing insulation layer and the second sensing insulation layer may include a silicon-based inorganic material, and the third sensing insulation layer may include an organic material.

According to some embodiments, the second conductive pattern layer may be connected with the first conductive pattern layer through contact holes defined in the second sensing insulation layer.

According to some embodiments, each of the first conductive pattern layer, the second conductive pattern layer, and the third conductive pattern layer may have a thickness of 100 nm to 1000 nm.

According to some embodiments, the input sensor may include first sensing patterns included in the third conductive pattern layer and second detection electrodes spaced apart from the first sensing patterns, and the second conductive pattern layer may include upper bridge patterns that connect the first sensing patterns spaced apart from each other through contact holes defined in the third sensing insulation layer.

According to some embodiments, the first conductive pattern layer may further include lower bridge patterns connected with the upper bridge patterns through contact holes defined in the second sensing insulation layer, and the upper bridge patterns and the lower bridge patterns may have the same shape in a plan view.

According to some embodiments, the third conductive pattern layer may be implemented with a plurality of mesh lines that cross each other and define mesh openings.

According to some embodiments, the input sensor may sense an external input using a capacitance method.

According to some embodiments, the input sensor may include a first group of electrodes that sense an external input using a capacitance method and a second group of electrodes that sense an external input using an electromagnetic induction method.

According to some embodiments, the first group of electrodes may include a first-first detection electrode including a first-first sensing electrode and a first-second sensing electrode spaced part from each other with a first space therebetween in a first direction and a first-second detection electrode that is insulated from the first-first detection electrode and that includes a second-first sensing electrode and a second-second sensing electrode spaced apart from each other with a second space therebetween in a second direction crossing the first direction. According to some embodiments, the second group of electrodes may include a second-first detection electrode that is in the first space and that extends in the second direction and a second-second detection electrode that is in the second space and that extends in the first direction.

### BRIEF DESCRIPTION OF THE DRAWINGS

The above and other characteristics and features of embodiments according to the present disclosure will become more apparent by describing in more detail aspects of some embodiments thereof with reference to the accompanying drawings.
FIG. 1A is a perspective view of an electronic device according to some embodiments of the present disclosure.
FIGS. 1B and 1C are views illustrating a folded state of the electronic device illustrated in FIG. 1A.
FIG. 2 is an exploded perspective view of the electronic device illustrated in FIG. 1A.
FIG. 3 is a sectional view of a display device corresponding to the line I-I' illustrated in FIG. 2.
FIG. 4 is a sectional view of a display module according to some embodiments of the present disclosure.
FIG. 5 is a plan view of a display panel according to some embodiments of the present disclosure.
FIG. 6 is a sectional view of the display module according to some embodiments of the present disclosure.
FIG. 7A is a plan view of an input sensor according to some embodiments of the present disclosure.
FIG. 7B is an enlarged plan view of area TT' illustrated in FIG. 7A.
FIG. 7C is a sectional view of the input sensor corresponding to the line II-II' illustrated in FIG. 7B.
FIG. 8A is a plan view of an input sensor according to some embodiments of the present disclosure.
FIG. 8B is an enlarged plan view of the area AA' illustrated in FIG. 8A.
FIG. 8C is an enlarged plan view illustrating a part of detection electrodes illustrated in FIG. 8A.
FIG. 8D is a sectional view of the input sensor corresponding to the line III-III' illustrated in FIG. 8B.
FIG. 8E is a sectional view of the input sensor corresponding to the line IV-IV' illustrated in FIG. 8B.
FIGS. 9A to 9E are plan views illustrating operation periods of the detection electrodes of FIG. 8A.
FIG. 10 is a sectional view of an input sensor according to some embodiments of the present disclosure.
FIG. 11 is a sectional view of an input sensor according to some embodiments of the present disclosure.
FIG. 12 is a sectional view of an input sensor according to some embodiments of the present disclosure.
FIG. 13 is a sectional view of an input sensor according to some embodiments of the present disclosure.

### DETAILED DESCRIPTION

In this specification, when it is mentioned that a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, aspects of some embodiments of the present disclosure will be described in more detail with reference to the accompanying drawings.

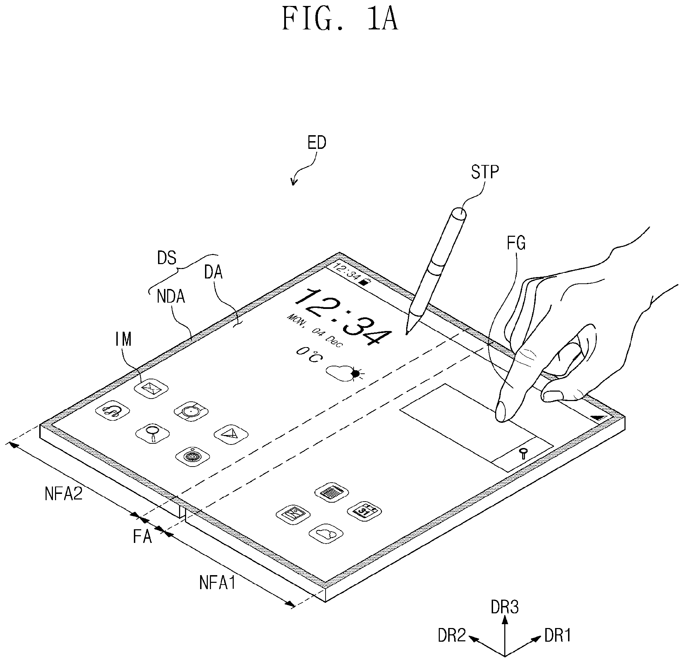

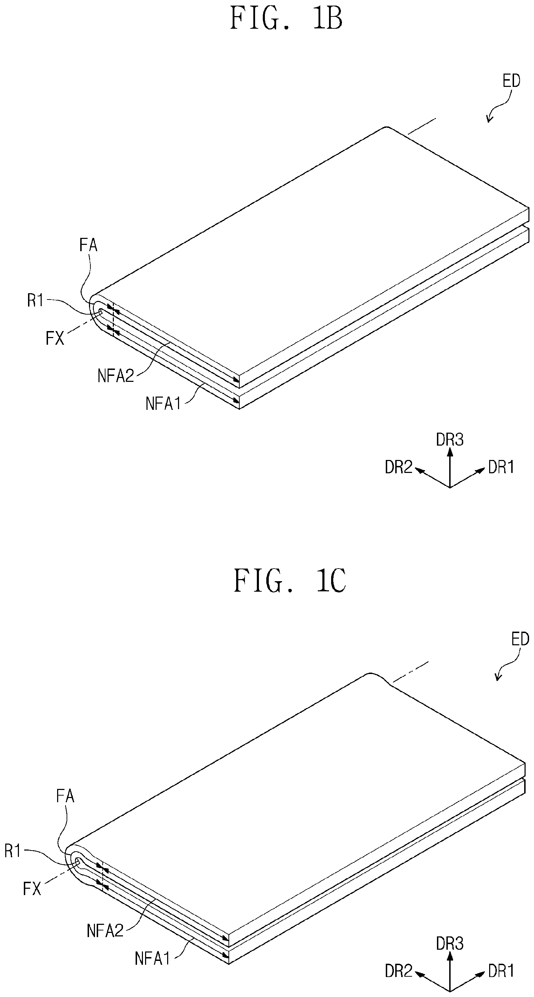

FIGS. 1A to 1C are perspective views of an electronic device according to some embodiments of the present disclosure. FIG. 1A illustrates an unfolded state of the electronic device, and FIGS. 1B and 1C illustrate a folded state of the electronic device.

Referring to FIGS. 1A to 1C, the electronic device ED according to some embodiments of the present disclosure may include a display surface DS defined by a first direction DR1 and a second direction DR2 crossing the first direction DR1. The electronic device ED may provide an image IM to a user through the display surface DS.

The display surface DS may include a display area DA and a non-display area NDA around the display area DA. The display area DA may display the image IM, and the non-display area NDA may not display the image IM. The non-display area NDA may surround (e.g., in a periphery or outside a footprint of) the display area DA. However, embodiments according to the present disclosure are not limited thereto, and the shape of the display area DA and the shape of the non-display area NDA may be modified.

Hereinafter, a direction perpendicular (or substantially perpendicular) to a plane defined by the first direction DR1 and the second direction DR2 is defined as a third direction DR3. Front surfaces and rear surfaces of members are distinguished from each other based on the third direction DR3. The expressions "when viewed from above the plane" or "in a plan view" used herein may mean that it is viewed in the third direction DR3. Hereinafter, the first to third directions DR1, DR2, and DR3 are directions indicated by first to third directional axes, respectively, and are assigned with the same reference numerals as those of the first to third directional axes.

The electronic device ED may include a folding area FA and a plurality of non-folding areas NFA1 and NFA2. The non-folding areas NFA1 and NFA2 may include the first non-folding area NFA1 and the second non-folding area NFA2. The folding area FA may be located between the first non-folding area NFA1 and the second non-folding area NFA2 in the second direction DR2. According to some embodiments, the foldable electronic device ED is illustrated as an example. However, embodiments according to the present disclosure are not limited thereto. The electronic device ED may be a bar-type electronic device, a rollable electronic device, or a slidable electronic device.

The electronic device ED may sense an input of a stylus pen STP and an input by the user's body FG. A finger is illustrated as an example of the user's body FG. The electronic device ED may sense an input of the stylus pen STP during a first mode period and an input of the user's body FG during a second mode period through time division driving.

As illustrated in FIG. 1B, the folding area FA may be folded about a folding axis FX parallel to the first direction DR1 without damaging the electronic device ED. The folding area FA has a certain curvature and a radius of curvature R1. The electronic device ED may be folded in an in-folding manner such that the first non-folding area NFA1 and the second non-folding area NFA2 face each other and the display surface DS is not exposed to the outside.

According to some embodiments of the present disclosure, the electronic device ED may be folded in an out-folding manner such that the display surface DS is exposed to the outside. According to some embodiments of the present disclosure, the electronic device ED may be configured such that an in-folding operation and an out-folding operation are repeatedly performed in the unfolded state, but is not limited thereto. According to some embodiments of the present disclosure, the electronic device ED may be configured to select one of an unfolding operation, an in-folding operation, and an out-folding operation.

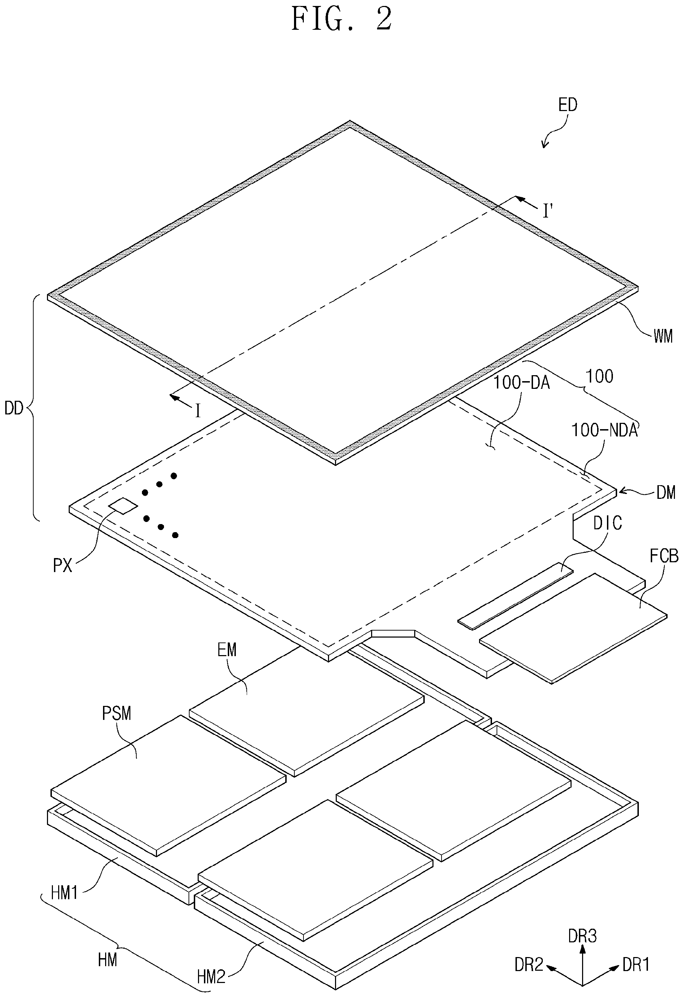

As illustrated in FIG. 1B, the distance between the first non-folding area NFA1 and the second non-folding area NFA2 may be the same (or substantially the same) as twice the radius of curvature R1. However, as illustrated in FIG. 1C, the distance between the first non-folding area NFA1 and the second non-folding area NFA2 may be smaller than twice the radius of curvature R1. FIGS. 1B and 1C are illustrated based on the display surface DS, and housings HM (refer to FIG. 2) that form the exterior of the electronic device ED may make contact with each other in distal end areas of the first non-folding area NFA1 and the second non-folding area NFA2.

FIG. 2 is an exploded perspective view of the electronic device according to some embodiments of the present disclosure.

As illustrated in FIG. 2, the electronic device ED may include a display device DD, electronic modules EM, power supply modules PSM, and the housings HM. According to some embodiments, the electronic device ED may further include a mechanical structure for controlling a folding operation of the display device DD. In FIG. 2, adhesive layers may be utilized to couple components to each other.

The display device DD generates images and senses external inputs. The display device DD includes a window WM and a display module DM. The window WM provides the front surface of the electronic device ED. The window WM will be described below in more detail. The display device DD may further include an additional component between the window WM and the display module DM, or may further include an additional component under the display module DM.

The display module DM may include at least a display panel 100. Although only the display panel 100 among stacked structures of the display module DM is illustrated in FIG. 2, the display module DM may further include a plurality of components located on the display panel 100. The stacked structures of the display module DM will be described below in more detail.

The display panel 100 is not particularly limited. For example, the display panel 100 may be one of a liquid crystal display panel, an electrophoretic display panel, a microelectromechanical system (MEMS) display panel, an electrowetting display panel, an organic light emitting display panel, an inorganic light emitting display panel, and a quantum-dot display panel. In addition, the display panel 100 according to some embodiments of the present disclosure may include a micro light emitting element and is not limited to any one embodiment.

The display panel 100 includes a display area 100-DA and a non-display area 100-NDA that correspond to the display area DA (refer to FIG. 1A) and the non-display area NDA (refer to FIG. 1A) of the electronic device ED. Pixels PX are located in the display area 100-DA. The pixels PX are not located in the non-display area 100-NDA, and sensing lines that provide voltages to the pixels PX are located in the non-display area 100-NDA. The expression "one area/portion corresponds to another area/portion" used herein means that the areas/portions overlap each other and is not limited to having the same area.

As illustrated in FIG. 2, a driver IC DIC may be located on the non-display area 100-NDA of the display panel 100. A flexible circuit board FCB may be coupled to the non-display area 100-NDA of the display panel 100. The flexible circuit board FCB may be connected to the main circuit board. The main circuit board may be one electronic part constituting the electronic modules EM. In addition, the electronic modules EM may further include a control module (e.g., an application processor), a wireless communication module, and an image input module.

According to some embodiments, among the electronic modules EM, a camera module may be located under the display panel 100 to overlap the display area 100-DA. A portion of the display area 100-DA that overlaps the camera module may be an area having a higher light transmittance than an adjacent area. The area having a relatively high light transmittance may be defined as an area where a hole is formed through the display panel 100 or at least some of the components included in the pixels PX are not deposited or subjected to patterning.

The driver IC DIC may include driving elements (e.g., a data driving circuit) for driving the pixels PX of the display panel 100. Although FIG. 2 illustrates the structure in which the driver IC DIC is mounted on the display panel 100, embodiments according to the present disclosure are not limited thereto. For example, the driver IC DIC may be mounted on the flexible circuit board FCB.

Referring to FIG. 2, the electronic modules EM may be located in a first housing HM1 and a second housing HM2, respectively, and the power supply modules PSM may be located in the first housing HM1 and the second housing HM2, respectively. According to some embodiments, the electronic module EM located in the first housing HM1 and the electronic module EM located in the second housing HM2 may be electrically connected with each other through a flexible circuit board. The housings HM are coupled with the display device DD, particularly, the window WM and accommodate the other modules. Although the housings HM are illustrated as including the first and second housings HM1 and HM2 separated from each other, embodiments according to the present disclosure are not limited thereto. According to some embodiments, the electronic device ED may further include a hinge structure for connecting the first and second housings HM1 and HM2.

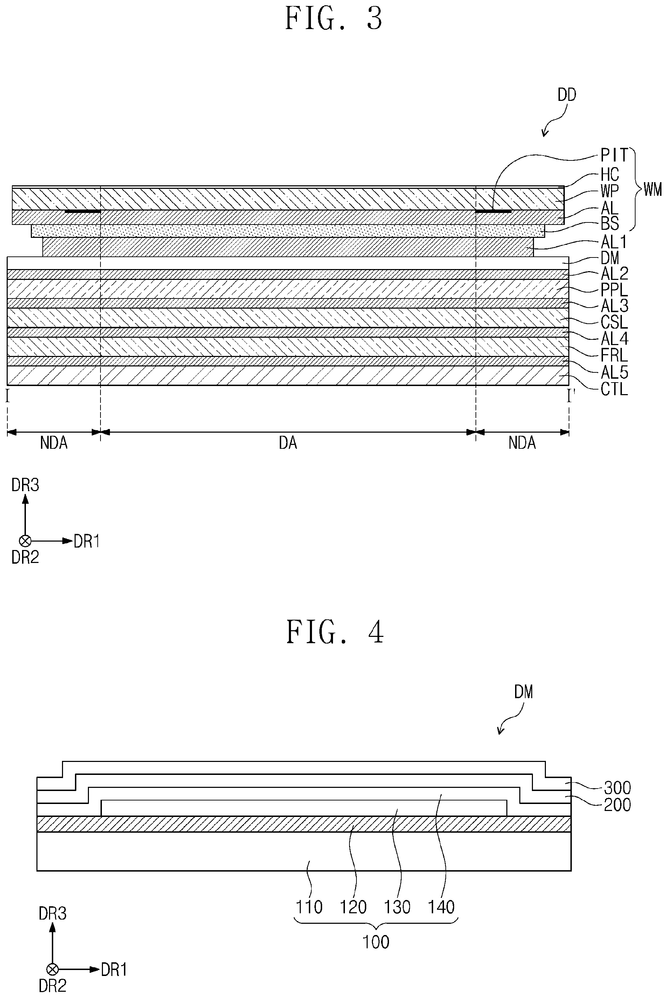

FIG. 3 is a sectional view of the display device DD corresponding to the line I-I' illustrated in FIG. 2.

Referring to FIG. 3, the display device DD may include the window WM, the display module DM, a panel protection layer PPL, a cushion layer CSL, a shielding layer FRL, a conductive layer CTL, and first to fifth adhesive layers AL1 to AL5. Each of the first to fifth adhesive layers AL1 to AL5 couples two components stacked adjacent to each other among the components. The first to fifth adhesive layers AL1 to AL5 may include a pressure sensitive adhesive (PSA) or an optically clear adhesive (OCA). However, the types of adhesive layers are not limited thereto.

The window WM provides the outer surface of the display device DD. The window WM may include a base layer BS, a window protection layer WP, a hard coating layer HC, and a printed layer PIT (or, a black matrix layer). The base layer BS may have a property of being optically clear. The base layer BS may include glass or a synthetic resin film. The window protection layer WP is attached to the base layer BS through an adhesive layer AL. The window protection layer WP may include a flexible plastic material such as polyimide or polyethylene terephthalate. The hard coating layer HC may be located on the upper surface of the window protection layer WP.

The printed layer PIT may be located on the lower surface of the window protection layer WP. The printed layer PIT may be a black matrix layer. The printed layer PIT may be black in color. However, the color of the printed layer PIT is not limited thereto. The printed layer PIT may be adjacent to the periphery of the window protection layer WP. The printed layer PIT may overlap the non-display area NDA. However, a stacked structure of the window WM is not necessarily limited to the above-described structure.

The panel protection layer PPL may be located under the display module DM. The panel protection layer PPL may protect the bottom of the display module DM. The panel protection layer PPL may include a flexible plastic material. For example, the panel protection layer PPL may include polyethylene terephthalate (PET). According to some embodiments of the present disclosure, the panel protection layer PPL may be omitted.

The cushion layer CSL is located under the panel protection layer PPL. The cushion layer CSL absorbs external impact. The cushion layer CSL may include foamed plastic. According to some embodiments of the present disclosure, the cushion layer CSL may be omitted.

The shielding layer FRL may be located under the cushion layer CSL. The shielding layer FRL may include a material having a high transmittance. The shielding layer FRL may include a ferromagnetic material. The shielding layer FRL may include a magnetic metal powder layer. The magnetic metal powder layer may include a base resin and magnetic metal powder mixed in the base resin. According to some embodiments of the present disclosure, the shielding layer FRL may be omitted.

The conductive layer CTL may be located under the shielding layer FRL. The conductive layer CTL blocks electromagnetic waves generated from the electronic modules EM of FIG. 2 such that the electromagnetic waves do not interfere with the display module DM (noise shielding effect). The conductive layer CTL may include a diamagnetic material. In addition, the conductive layer CTL may radiate heat generated from the display module DM like the driver IC DIC (refer to FIG. 2) (heat radiating effect).

The conductive layer CTL may include a metal layer such as copper, aluminum, gold, or titanium. The conductive layer CTL may include a metal oxide layer such as ITO or IZO. The conductive layer CTL may include carbon nanotubes, conductive polymer-coated carbon nanotubes, or graphite. According to some embodiments of the present disclosure, the conductive layer CTL may be omitted.

FIG. 4 is a sectional view of the display module DM according to some embodiments of the present disclosure. Referring to FIG. 4, the display module DM may include the display panel 100, an input sensor 200, and an anti-reflector 300.

The display panel 100 may include a base layer 110, a driving element layer 120, a light emitting element layer 130, and an encapsulation layer 140. The base layer 110 may provide a base surface on which the driving element layer 120 is located. The base layer 110 may be a rigid substrate, or may be a flexible substrate that is able to be bent, folded, or rolled. The base layer 110 may be a glass substrate, a metal substrate, a polymer substrate, or the like. However, embodiments of the present disclosure are not limited thereto, and the base layer 110 may include an inorganic layer, an organic layer, or a composite layer.

The base layer 110 may have a multi-layer structure. For example, the base layer 110 may include a first synthetic resin layer, an inorganic layer having a multi-layer structure or a single-layer structure, and a second synthetic resin layer located on the inorganic layer having the multi-layer structure or the single-layer structure. Each of the first and second synthetic resin layers may include a polyimide-based resin, but is not particularly limited.

The driving element layer 120 may be located on the base layer 110. The driving element layer 120 may include an insulating layer, a semiconductor pattern, a conductive pattern, and a signal line. The driving element layer 120 includes driving circuits of the pixels PX described with reference to FIG. 2. The light emitting element layer 130 may be located on the driving element layer 120. The light emitting element layer 130 may include light emitting elements included in the respective pixels PX described with reference to FIG. 2.

The encapsulation layer 140 may be located on the light emitting element layer 130. The encapsulation layer 140 may protect the light emitting element layer 130 from foreign matter such as moisture, oxygen, and dust particles. The encapsulation layer 140 may include at least one inorganic layer. The encapsulation layer 140 may include a stacked structure of an inorganic layer/an organic layer/an inorganic layer.

The input sensor 200 may be located on the display panel 100. The input sensor 200 may sense at least one of an input of the stylus pen STP or an input by the user's body FG illustrated in FIG. 1A. The input sensor 200 may be formed on the display panel 100 through a continuous process. In this case, the input sensor 200 may be directly located on the display panel 100. As used herein, the expression "component B is directly located on component A" means that an adhesive layer is not located between component A and component B.

The anti-reflector 300 may be located on the input sensor 200. The anti-reflector 300 may decrease the reflectance of external light. The anti-reflector 300 may be directly located on the input sensor 200 through a continuous process.

The anti-reflector 300 may include color filters. The color filters have colors corresponding to the colors of source light. For example, a red color filter is located on a light emitting element that generates red light. The anti-reflector 300 may further include a light blocking pattern located between the color filters.

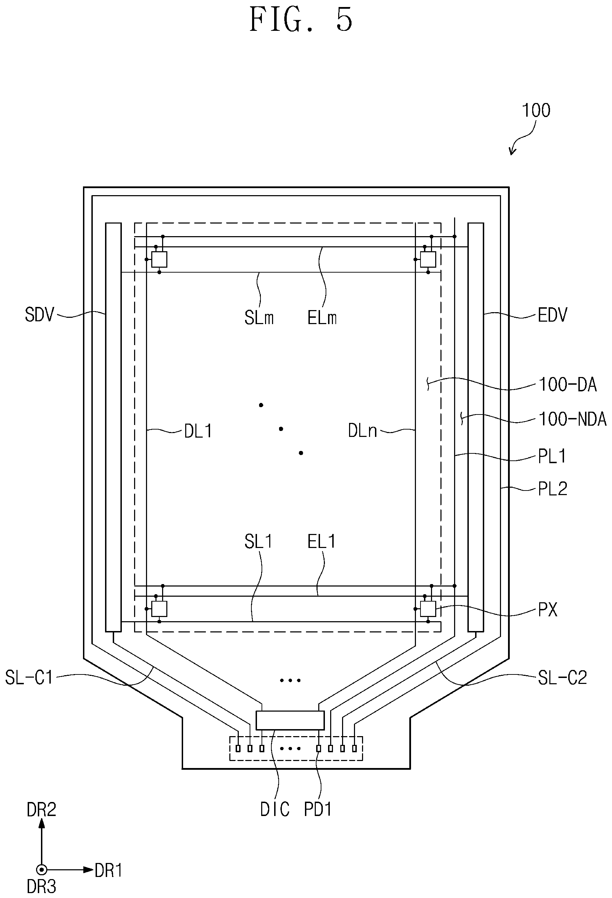

FIG. 5 is a plan view of the display panel 100 according to some embodiments of the present disclosure.

Referring to FIG. 5, the display panel 100 may include the pixels PX, a scan driving circuit SDV, an emission driving circuit EDV, a plurality of sensing lines, and a first pad PD1 including a plurality of pads. The driver IC DIC mounted on the non-display area 100-NDA may include the data driving circuit. According to some embodiments of the present disclosure, the data driving circuit may also be integrated into the display panel 100 like the scan driving circuit SDV and the emission driving circuit EDV.

The plurality of sensing lines may include a plurality of scan lines SL1 to SLm, a plurality of data lines DL1 to DLn, a plurality of emission lines EL1 to ELm, first and second control lines SL-C1 and SL-C2, and first and second power lines PL1 and PL2. Here, "m" and "n" are natural numbers of 2 or more.

The scan lines SL1 to SLm may extend in the first direction DR1 and may be connected to the pixels PX and the scan driving circuit SDV. The data lines DL1 to DLn may extend in the second direction DR2 and may be connected to the pixels PX and the driver IC DIC. The emission lines EL1 to ELm may extend in the first direction DR1 and may be connected to the pixels PX and the emission driving circuit EDV.

The first power line PL1 receives a first power voltage, and the second power line PL2 receives a second power voltage having a lower level than the first power voltage. According to some embodiments, a second electrode (that is, a cathode) of a light emitting element is connected to the second power line PL2.

The first control line SL-C1 may be connected to the scan driving circuit SDV and may extend toward the lower end of the display panel 100. The second control line SL-C2 may be connected to the emission driving circuit EDV and may extend toward the lower end of the display panel 100. The first pad PD1 may be located on the non-display area 100-NDA adjacent to the lower end of the display panel 100 and may be closer to the lower end of the display panel 100 than the driver IC DIC. The first pad PD1 may be connected to the driver IC DIC and some of the sensing lines.

The scan driving circuit SDV may generate a plurality of scan signals, and the scan signals may be applied to the pixels PX through the scan lines SL1 to SLm. The driver IC DIC may generate a plurality of data voltages, and the data voltages may be applied to the pixels PX through the data lines DL1 to DLn. The emission driving circuit EDV may generate a plurality of emission signals, and the emission signals may be applied to the pixels PX through the emission lines EL1 to ELm.

The pixels PX may receive the data voltages in response to the scan signals. The pixels PX may display images by emitting light having luminance corresponding to the data voltages in response to the emission signals.

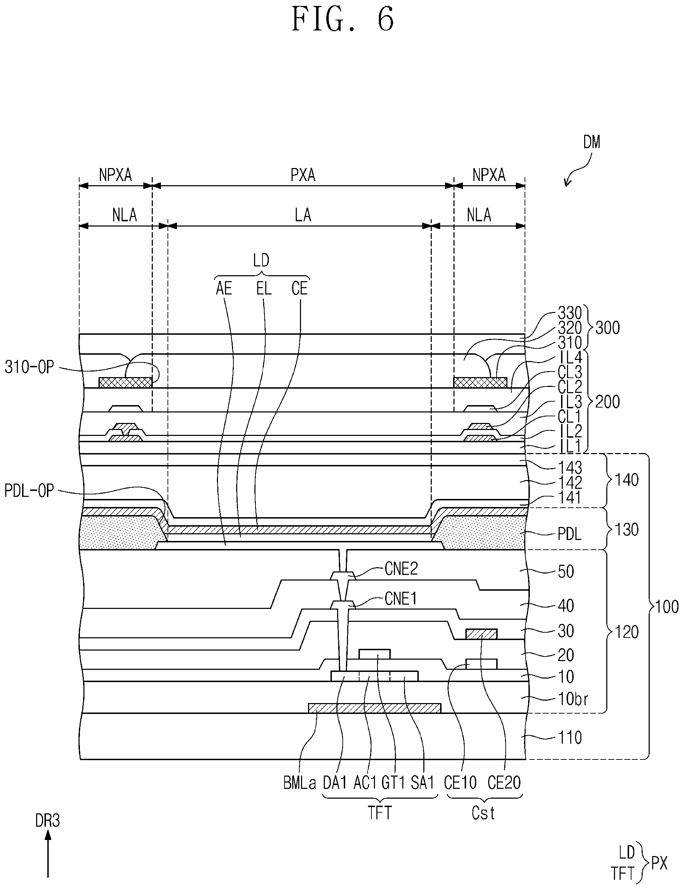

FIG. 6 is a sectional view of the display module according to some embodiments of the present disclosure.

In FIG. 6, a section corresponding to one pixel PX is illustrated. An emissive area LA may be defined by an opening PDL-OP defined in a pixel defining layer PDL. A non-emissive area NLA may overlap the pixel defining layer PDL.

In FIG. 6, a light emitting element LD and a transistor TFT included in the pixel PX are illustrated. The transistor TFT may be one of a plurality of transistors included in a driving circuit of the pixel PX. According to some embodiments, the transistor TFT is described as a silicon transistor. However, the transistor TFT may be a metal oxide transistor.

A buffer layer 10br may be located on the base layer 110. The buffer layer 10br may prevent or reduce diffusion of metal atoms or other contaminants or impurities from the base layer 110 to a semiconductor pattern on the upper side of the buffer layer 10br. The semiconductor pattern includes an active area AC1 of the transistor TFT.

A rear metal layer BMLa may be located under the transistor TFT. The rear metal layer BMLa may block external light from reaching the transistor TFT. The rear metal layer BMLa may be located between the base layer 110 and the buffer layer 10br. According to some embodiments of the present disclosure, an inorganic barrier layer may be additionally located between the rear metal layer BMLa and the buffer layer 10br. The rear metal layer BMLa may be connected with an electrode or a line and may receive a constant voltage or a signal from the electrode or the line.

The semiconductor pattern may be located on the buffer layer 10br. The semiconductor pattern may include a silicon semiconductor. For example, the silicon semiconductor may include amorphous silicon or polycrystalline silicon. For example, the semiconductor pattern may include low-temperature poly silicon.

The semiconductor pattern may include first areas having a high conductivity and a second area having a low conductivity. The first areas may be doped with an N-type dopant or a P-type dopant. A P-type transistor may include a doped area that is doped with a P-type dopant, and an N-type transistor may include a doped area that is doped with an N-type dopant. The second area may be an un-doped area, or may be an area more lightly doped than the first areas.

The first areas may have a higher conductivity than the second area and may serve as electrodes or signal lines. The second area may correspond (or substantially correspond) to the active area (or, the channel) of the transistor. In other words, one portion of the semiconductor pattern may be the active area of the transistor, another portion may be a source or drain of the transistor, and the other portion may be a connecting electrode or a connecting detection line.

The source area (or, the source) SA1, the active area (or, the channel) AC1, and the drain area (or, the drain) DA1 of the transistor TFT may be formed from the semiconductor pattern. The source area SA1 and the drain area DA1 may extend from the active area AC1 in opposite directions on the section.

A first insulating layer 10 may be located on the buffer layer 10br. The first insulating layer 10 may commonly overlap the plurality of pixels PX (refer to FIG. 1) and may cover the semiconductor pattern. The first insulating layer 10 may include an inorganic layer and/or an organic layer and may have a single-layer structure or a multi-layer structure. The inorganic layer may include at least one of aluminum oxide, titanium oxide, silicon oxide, silicon nitride, silicon oxy nitride, zirconium oxide, or hafnium oxide.

According to some embodiments, the first insulating layer 10 may be a single silicon oxide layer. Not only the first insulating layer 10 but also other insulating layers of the driving element layer 120 that will be described below may be inorganic layers and/or organic layers and may have a single-layer structure or a multi-layer structure. The inorganic layers may include at least one of the aforementioned materials, but are not limited thereto.

A gate GT1 of the transistor TFT is located on the first insulating layer 10. The gate GT1 may be a portion of a metal pattern. The gate GT1 overlaps the active area AC1. The gate GT1 may function as a mask in a process of doping the semiconductor pattern. The gate GT1 may include titanium (Ti), silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), indium tin oxide (ITO), or indium zinc oxide (IZO), but is not particularly limited thereto.

A second insulating layer 20 may be located on the first insulating layer 10 and may cover the gate GT1. A third insulating layer 30 may be located on the second insulating layer 20. A second electrode CE20 of a storage capacitor Cst may be located between the second insulating layer 20 and the third insulating layer 30. In addition, a first electrode CE10 of the storage capacitor Cst may be located between the first insulating layer 10 and the second insulating layer 20.

A first connecting electrode CNE1 may be located on the third insulating layer 30. The first connecting electrode CNE1 may be connected to the drain area DA1 of the transistor TFT through a contact hole penetrating the first to third insulating layers 10, 20, and 30.

A fourth insulating layer 40 may be located on the third insulating layer 30. A second connecting electrode CNE2 may be located on the fourth insulating layer 40. The second connecting electrode CNE2 may be connected to the first connecting electrode CNE1 through a contact hole penetrating the fourth insulating layer 40. A fifth insulating layer 50 may be located on the fourth insulating layer 40 and may cover the second connecting electrode CNE2. The stacked structure of the first to fifth insulating layers 10, 20, 30, 40, and 50 is merely illustrative, and an additional conductive layer and an additional insulating layer may be further arranged in addition to the first to fifth insulating layers 10, 20, 30, 40, and 50.

Each of the fourth insulating layer 40 and the fifth insulating layer 50 may be an organic layer. For example, the organic layer may include a general purpose polymer such as benzocyclobutene (BCB), polyimide, hexamethyldisiloxane (HMDSO), Polymethylmethacrylate (PMMA), or Polystyrene (PS), a polymer derivative having a phenolic group, an acrylate-based polymer, an imide-based polymer, an aryl ether-based polymer, an amide-based polymer, a fluorine-based polymer, a p-xylene-based polymer, a vynyl alcohol-based polymer, or a blend thereof.

The light emitting element LD may include a first electrode (or, a pixel electrode) AE, an emissive layer EL, and a second electrode (or, a common electrode) CE. The first electrode AE may be located on the fifth insulating layer 50. The first electrode AE may be a (semi-) transmissive electrode or a reflective electrode. The first electrode AE may include a reflective layer formed of Ag, Mg, Al, Pt, Pd, Au, Ni, Nd, Ir, Cr, or a compound thereof and a transparent or translucent electrode layer formed on the reflective layer. The transparent or translucent electrode layer may include at least one selected from the group consisting of indium tin oxide (ITO), indium zinc oxide (IZO), indium gallium zinc oxide (IGZO), zinc oxide (ZnO), or indium oxide (In2O3) and aluminum-doped zinc oxide (AZO). For example, the first electrode AE may include a stacked structure of ITO/Ag/ITO.

The pixel defining layer PDL may be located on the fifth insulating layer 50. According to some embodiments, the pixel defining layer PDL may have a property of absorbing light. For example, the pixel defining layer PDL may be black in color. The pixel defining layer PDL may include a black coloring agent. The black coloring agent may include a black dye or a black pigment. The black coloring agent may include carbon black, metal such as chromium, or oxide thereof. The pixel defining layer PDL may correspond to a light blocking pattern having light blocking characteristics.

The pixel defining layer PDL may cover a portion of the first electrode AE (e.g., the anode). For example, the opening PDL-OP for exposing a portion of the first electrode AE may be defined in the pixel defining layer PDL. As described above, the opening PDL-OP of the pixel defining layer PDL may define the emissive area LA.

The pixel defining layer PDL may increase the distance between the edge of the first electrode AE and the second electrode CE (e.g., the cathode). Accordingly, the pixel defining layer PDL may serve to prevent or reduce instances of an arc occurring at the edge of the first electrode AE.

According to some embodiments, a hole control layer may be located between the first electrode AE and the emissive layer EL. The hole control layer may include a hole transport layer and may further include a hole injection layer. An electron control layer may be located between the emissive layer EL and the second electrode CE. The electron control layer may include an electron transport layer and may further include an electron injection layer.

The encapsulation layer 140 may be located on the light emitting element layer 130. The encapsulation layer 140 may include an inorganic layer 141, an organic layer 142, and an inorganic layer 143 sequentially stacked one above another. However, layers constituting the encapsulation layer 140 are not limited thereto.

The inorganic layers 141 and 143 may protect the light emitting element layer 130 from moisture and oxygen, and the organic layer 142 may protect the light emitting element layer 130 from foreign matter such as dust particles. The inorganic layers 141 and 143 may include a silicon nitride layer, a silicon oxy nitride layer, a silicon oxide layer, a titanium oxide layer, or an aluminum oxide layer. The organic layer 142 may include an acrylic organic layer, but is not limited thereto.

The input sensor 200 may be located on the display panel 100. The input sensor 200 may include a first sensing insulation layer IL1, a first conductive pattern layer CL1, a second sensing insulation layer IL2, a second conductive pattern layer CL2, a third sensing insulation layer IL3, a third conductive pattern layer CL3, and a fourth sensing insulation layer IL4 sequentially stacked one above another. The first sensing insulation layer IL1 may be directly located on the encapsulation layer 140.

According to some embodiments of the present disclosure, one of the first to fourth sensing insulation layers IL1, IL2, IL3, and IL4 may be omitted. When the first sensing insulation layer IL1 is omitted, the first conductive pattern layer CL1 may be located on the uppermost insulating layer of the encapsulation layer 140. The fourth sensing insulation layer IL4 may be replaced with an adhesive layer or an insulating layer of the anti-reflector 300 located on the input sensor 200.

The first conductive pattern layer CL1 may include first conductive patterns, the second conductive pattern layer CL2 may include second conductive patterns, and the third conductive pattern layer CL3 may include third conductive patterns.

The first conductive pattern layer CL1 may be located on the first sensing insulation layer IL1 and may be covered by the second sensing insulation layer IL2. The second conductive pattern layer CL2 may be located on the second sensing insulation layer IL2 and may be covered by the third sensing insulation layer IL3. The third conductive pattern layer CL3 may be located on the third sensing insulation layer IL3 and may be covered by the fourth sensing insulation layer IL4.

According to the present disclosure, the first conductive pattern layer CL1 may be connected with the second conductive pattern layer CL2 through contact holes defined in the second sensing insulation layer IL2, and the first conductive pattern layer CL1 and the second conductive pattern layer CL2may receive the same voltage.

Each of the first to third conductive pattern layers CL1, CL2, and CL3 may have a single-layer structure, or may have a multi-layer structure sequentially stacked in the third direction DR3. A conductive pattern layer having a multi-layer structure may include at least two of transparent conductive layers and metal layers. The multi-layered conductive pattern may include metal layers including different metals. The transparent conductive layers may include indium tin oxide (ITO), indium zinc oxide (IZO), zinc oxide (ZnO), indium tin zinc oxide (ITZO), PEDOT, metal nano-wire, or graphene. The metal layers may include molybdenum, silver, titanium, copper, aluminum, and an alloy thereof.

According to some embodiments, the first conductive pattern layer CL1, the second conductive pattern layer CL2, and the third conductive pattern layer CL3 may each have a thickness of 100 nm to 1000 nm. In more detail, the first conductive pattern layer CL1 may have a thickness of 400 nm to 600 nm, the second conductive pattern layer CL2 may have a thickness of 500 nm to 700 nm, and the third conductive pattern layer CL3 may have a thickness of 400 nm to 600 nm. However, the thicknesses are not limited to the mentioned ranges and combinations of such.

According to some embodiments, each of the first to fourth sensing insulation layers IL1, IL2, IL3, and IL4 may include an inorganic layer or an organic layer. The first sensing insulation layer IL1 and the second sensing insulation layer IL2 may include a silicon-based inorganic material. For example, the first sensing insulation layer IL1 and the second sensing insulation layer IL2 may include silicon oxide, silicon nitride, or silicon oxy nitride.

According to some embodiments of the present disclosure, the third sensing insulation layer IL3 and the fourth sensing insulation layer IL4 may include an organic material. The organic material may include at least one of an acrylic resin, a methacrylic resin, a polyisoprene resin, a vinyl resin, an epoxy resin, a urethane-based resin, a cellulosic resin, a siloxane-based resin, a polyimide resin, a polyamide resin, or a perylene-based resin.

According to some embodiments, when a camera module is located under the display panel 100 described with reference to FIG. 5 to overlap the display area 100-DA, the input sensor 200 may further include an interlayer insulating layer. The interlayer insulating layer may be located between the first sensing insulation layer IL1 and the second sensing insulation layer IL2. The interlayer insulating layer may be an organic layer. The interlayer insulating layer may compensate for a step generated in a process of forming a hole in the area of the display panel 100 (refer to FIG. 5) that is adjacent to the camera module.

The anti-reflector 300 may be located on the input sensor 200. The anti-reflector 300 may include a light blocking pattern 310, a color filter 320, and a planarization layer 330. According to some embodiments of the present disclosure, the light blocking pattern 310 may be omitted.

A material constituting the light blocking pattern 310 is not particularly limited as long as it is a material capable of absorbing light. The light blocking pattern 310 may be a layer having a black color. According to some embodiments, the light blocking pattern 310 may include a black coloring agent. The black coloring agent may include a black dye or a black pigment. The black coloring agent may include carbon black, metal such as chromium, or oxide thereof.

The light blocking pattern 310 may overlap the third conductive pattern layer CL3 when viewed from above the plane (or in a plan view). The light blocking pattern 310 may prevent or reduce reflection of external light by the first to third conductive pattern layers CL1, CL2, and CL3. The light blocking pattern 310 may have an opening 310-OP defined therein. The opening 310-OP of the light blocking pattern 310 may overlap the first electrode AE and may have a larger area than the opening PDL-OP of the pixel defining layer PDL. The opening 310-OP of the light blocking pattern 310 may be defined as a pixel area PXA. The pixel area PXA may be defined as an area through which light generated from the light emitting element LD and passing through the opening PDL-OP of the pixel defining layer PDL is emitted to the outside. As the area of the pixel area PXA is increased, the luminance of an image may be increased.

The color filter 320 may overlap at least the pixel area PXA. The color filter 320 may additionally overlap a non-pixel area NPXA. A portion of the color filter 320 may be located on the light blocking pattern 310. The color filter 320 may transmit light generated by the light emitting element LD and may block some wavelength bands of external light. Accordingly, the color filter 320 may decrease the reflection of external light by the first electrode AE or the second electrode CE.

The planarization layer 330 may cover the light blocking pattern 310 and the color filter 320. The planarization layer 330 may include an organic material. The planarization layer 330 may provide a flat upper surface.

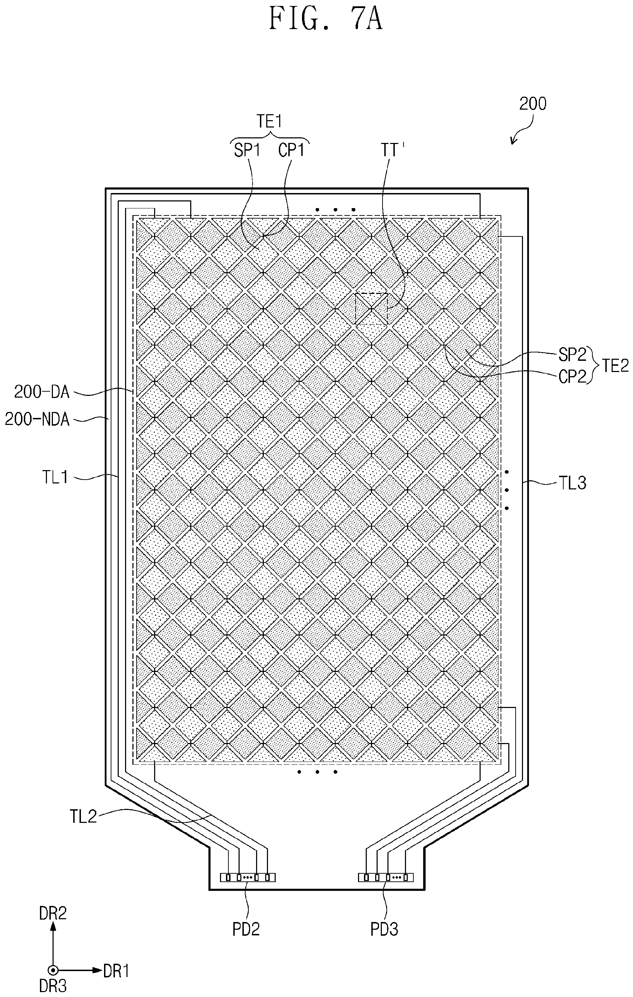

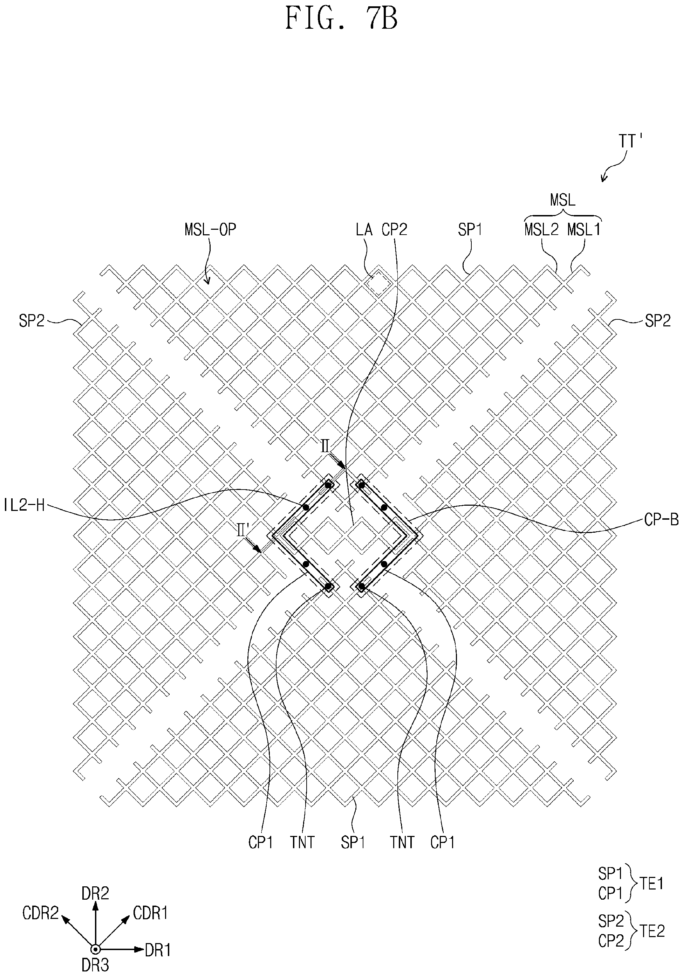

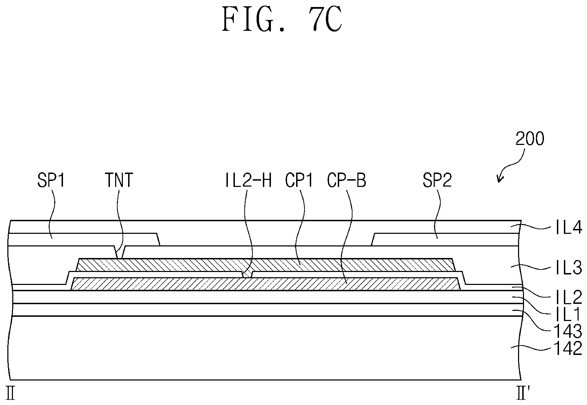

FIG. 7A is a plan view of the input sensor according to some embodiments of the present disclosure. FIG. 7B is an enlarged plan view of area TT' illustrated in FIG. 7A. FIG. 7C is a sectional view of the input sensor corresponding to line II-II' illustrated in FIG. 7B.

Referring to FIG. 7A, the input sensor 200 according to some embodiments may include detection electrodes TE1 and TE2 and sensing lines TL1, TL2, and TL3. The input sensor 200 includes a sensing area 200-DA and a non-sensing area 200-NDA that correspond to the display area DA (refer to FIG. 1A) and the non-display area NDA (refer to FIG. 1A) of the electronic device ED. The detection electrodes TE1 and TE2 may be located in the sensing area 200-DA, and the sensing lines TL1, TL2, and TL3 may be located in the non-sensing area 200-NDA.

The input sensor 200 according to some embodiments may obtain information about an external input through a change in the capacitance between the first detection electrodes TE1 and the second detection electrodes TE2. Accordingly, the input sensor 200 may sense only the first one of the input of the user's body FG and the input of the stylus pen STP that have been described with reference to FIG. 1A.

The first detection electrodes TE1 are arranged in the first direction DR1, and each of the first detection electrodes TE1 extends in the second direction DR2. Each of the first detection electrodes TE1 may include first sensing patterns SP1 and first bridge patterns CP1 (upper bridge patterns).

The first sensing patterns SP1 are located in the sensing area 200-DA. First sensing patterns SP1 included in one first detection electrode TE1 may be arranged in the second direction DR2. The first sensing patterns SP1 may have a rhombic shape. However, this is illustrative, and the first sensing patterns SP1 may have various shapes and are not limited to any one embodiment.

The first bridge patterns CP1 are located in the sensing area 200-DA. Each of the first bridge patterns CP1 may be located between first sensing patterns SP1 adjacent to each other in the second direction DR2. The first bridge patterns CP1 and the first sensing patterns SP1 may be located on different layers and may be connected through contact holes.

The second detection electrodes TE2 are arranged in the second direction DR2, and each of the second detection electrodes TE2 extends in the first direction DR1. Each of the second detection electrodes TE2 may include second sensing patterns SP2 and second bridge patterns CP2.

The second sensing patterns SP2 may be spaced apart from the first sensing patterns SP1. The first sensing patterns SP1 and the second sensing patterns SP2 may transmit and receive independent electrical signals without making contact with each other.

The second sensing patterns SP2 are located in the sensing area 200-DA. Second sensing patterns SP2 included in one second detection electrode TE2 may be arranged in the first direction DR1. The second sensing patterns SP2 may have the same shape as the first sensing patterns SP1. For example, the second sensing patterns SP2 may have a rhombic shape. However, this is illustrative, and the second sensing patterns SP2 may have various shapes and are not limited to any one embodiment.

Each of the second bridge patterns CP2 may be located between second sensing patterns SP2 adjacent to each other in the first direction DR1. According to some embodiments, second sensing patterns SP2 and second bridge patterns CP2 included in one second detection electrode TE2 may be formed in a one-body shape or an integrated pattern.

According to some embodiments, the first sensing patterns SP1, the second sensing patterns SP2, and the second bridge patterns CP2 may be located on the same layer, and the first bridge patterns CP1 may be located on another layer.

An arrangement relationship of the first sensing patterns SP1, the first bridge patterns CP1 (the upper bridge patterns), the second sensing patterns SP2, and the second bridge patterns CP2 are illustrated in the plan view of FIG. 7B, and the sensing insulation layers IL1, IL2, IL3, and IL4 described with reference to FIG. 6 are omitted.

According to some embodiments, the third conductive pattern layer CL3 described with reference to FIG. 6 may include mesh lines MSL. Accordingly, the first sensing patterns SP1 and the second detection electrodes TE2 may include the mesh lines MSL. The mesh lines MSL may include first mesh lines MSL1 extending in a first diagonal direction CDR1 and second mesh lines MSL2 extending in a second diagonal direction CDR2.

The mesh lines MSL1 and MSL2 do not overlap the emissive area LA described with reference to FIG. 6 and overlap the non-emissive area NLA. That is, the mesh lines MSL1 and MSL2 may overlap the pixel defining layer PDL described with reference to FIG. 6. The mesh lines MSL1 and MSL2 define a plurality of mesh openings MSL-OP. The plurality of mesh openings MSL-OP may correspond to the pixel areas PXA (refer to FIG. 6) provided for the respective pixels PX (refer to FIG. 6) in a one-to-one manner. The line widths of the mesh lines MSL1 and MSL2 may range from several nanometers to several micrometers.

According to some embodiments, the first sensing patterns SP1 and the second detection electrodes TE2 may be included in the third conductive pattern layer CL3 described with reference to FIG. 6. Accordingly, the first sensing patterns SP1 and the second detection electrodes TE2 may be located on the third sensing insulation layer IL3 and may be covered by the fourth sensing insulation layer IL4.

The first bridge patterns CP1 may be included in the second conductive pattern layer CL2 described with reference to FIG. 6. Accordingly, the first bridge patterns CP1 may be located on the second sensing insulation layer IL2 and may be covered by the third sensing insulation layer IL3.

As illustrated in FIG. 7C, the first sensing patterns SP1 may be connected with the first bridge patterns CP1 through contact holes TNT defined in the third sensing insulation layer IL3. Accordingly, even though the first sensing patterns SP1 are located on the same layer as the second detection electrodes TE2, the first sensing patterns SP1 and the second detection electrodes TE2 may be insulated from each other on the third sensing insulation layer IL3. The first bridge patterns CP1 and the second bridge patterns CP2 located on different layers may overlap each other when viewed from above the plane (or in a plan view).

The input sensor 200 according to some embodiments may further include lower bridge patterns CP-B. The lower bridge patterns CP-B may overlap the upper bridge patterns CP1. The lower bridge patterns CP-B may be included in the first conductive pattern layer CL1 described with reference to FIG. 6. Accordingly, the lower bridge patterns CP-B may be located on the first sensing insulation layer IL1 and may be covered by the second sensing insulation layer IL2.

According to some embodiments, the lower bridge patterns CP-B may have the same shape as the upper bridge patterns CP1 (the first bridge patterns) when viewed from above the plane (or in a plan view). That is, the shape of the first conductive pattern layer CL1 (refer to FIG. 6) may be the same as the shape of the second conductive pattern layer CL2 (refer to FIG. 6) when viewed from above the plane (or in a plan view).

As illustrated in FIG. 7C, the upper bridge patterns CP1 may be connected with the lower bridge patterns CP-B through contact holes IL2-H defined in the second sensing insulation layer IL2. According to the present disclosure, the upper bridge patterns CP1 and the lower bridge patterns CP-B may receive the same voltage. That is, the first conductive pattern layer CL1 (refer to FIG. 6) and the second conductive pattern layer CL2 (refer to FIG. 6) may receive the same voltage.

According to some embodiments, because the first conductive pattern layer CL1 (refer to FIG. 6) having the same shape as the second conductive pattern layer CL2 (refer to FIG. 6) is formed under the second conductive pattern layer CL2 (refer to FIG. 6), the input sensor 200 may have a thickness about two times greater than the thickness of an input sensor including the single second conductive pattern layer CL2 (refer to FIG. 6) in the related art. Accordingly, the input sensor 200 in which the resistances of the detection electrodes TE1 and TE2 (refer to FIG. 7A) are decreased may be provided.

Furthermore, because the input sensor 200 according to the present disclosure includes the first conductive pattern layer CL1 (refer to FIG. 6), a defect in the second conductive pattern layer CL2 (refer to FIG. 6) that is caused by increasing the thickness of the second conductive pattern layer CL2 (refer to FIG. 6) when the input sensor according to the comparative example includes only the single second conductive pattern layer CL2 (refer to FIG. 6) may be prevented or reduced.

Moreover, the input sensor 200 may prevent or reduce out-gassing defects caused by increasing the thickness of the third sensing insulation layer IL3 including an organic material for the purpose of planarization as the thickness of the second conductive pattern layer CL2 (refer to FIG. 6) is increased. Accordingly, the input sensor 200 with relatively improved sensing performance and quality may be provided.

In addition, according to the present disclosure, even if a defect occurs during the formation of the second sensing insulation layer IL2 and therefore the first conductive pattern layer CL1 (refer to FIG. 6) and the second conductive pattern layer CL2 (refer to FIG. 6) make contact with each other, the defect in the second sensing insulation layer IL2 may be offset because the first conductive pattern layer CL1 (refer to FIG. 6) and the second conductive pattern layer CL2 (refer to FIG. 6) have the same shape and receive the same voltage.

Referring again to FIG. 7A, the sensing lines TL1, TL2, and TL3 are located in the non-sensing area 200-NDA. The sensing lines TL1, TL2, and TL3 may include the first sensing lines TL1, the second sensing lines TL2, and the third sensing lines TL3.

First ends of the first sensing lines TL1 are connected to the first detection electrodes TE1, respectively. According to some embodiments, the first sensing lines TL1 are connected to upper ends of the first detection electrodes TE1, respectively. First ends of the second sensing lines TL2 are connected to lower ends of the first detection electrodes TE1, respectively. According to the present disclosure, the first detection electrodes TE1 may be connected to the first sensing lines TL1 and the second sensing lines TL2, respectively. Accordingly, the sensitivity depending on areas may be uniformly maintained for the first detection electrodes TE1 that have a greater length than the second detection electrodes TE2.

Meanwhile, this is illustrative, and in the input sensor 200 according to some embodiments of the present disclosure, either the first sensing lines TL1 or the second sensing lines TL2 may be omitted, and embodiments according to the present disclosure are not limited to any one embodiment.

First ends of the third sensing lines TL3 are connected to first ends of the second detection electrodes TE2, respectively. According to some embodiments, the third sensing lines TL3 are connected to light ends of the second detection electrodes TE2, respectively.

Each of the sensing lines TL1, TL2, and TL3 may be implemented with multiple layers located in at least one of the first to third conductive pattern layers CL1 to CL3. Each of the sensing lines TL1, TL2, and TL3, which is implemented with the multiple layers, may be connected through a contact hole defined in the sensing insulation layer located below.

The input sensor 200 may include second pads PD2 and third pads PD3. The second pads PD2 and the third pads PD3 may be located in areas spaced apart from each other in the first direction DR1. Each of the sensing lines TL1, TL2, and TL3 may be connected to at least one corresponding pad among the second pads PD2 and the third pads PD3. The second pads PD2 and the third pads PD3 may be adjacent to the lower end of the input sensor 200 when viewed from above the plane (or in a plan view). The first pads PD1 illustrated in FIG. 5 may be located between the second pads PD2 and the third pads PD3 when viewed from above the plane (or in a plan view).

The input sensor 200 may be divided into a left area and a right area with respect to the center of the input sensor 200 in the first direction DR1. The second pads PD2 are located in the left area, and the third pads PD3 are located in the right area. The first sensing lines TL1 may be connected to the second pads PD2. The third sensing lines TL3 may be connected to the third pads PD3. Some of the second sensing lines TL2 may be connected to the second pads PD2, and the remaining second sensing lines TL2 may be connected to the third pads PD3.

However, embodiments according to the present disclosure are not limited thereto, and a contact portion defined to penetrate at least one of the insulation layers included in the input sensor 200 may be defined in the input sensor 200. The contact portion may be connected with a contact portion defined in the non-display area 100-NDA of the display panel 100 (refer to FIG. 5). In this case, the input sensor 200 may further include connecting lines that connect the contact portion and the driver IC DIC (refer to FIG. 5).

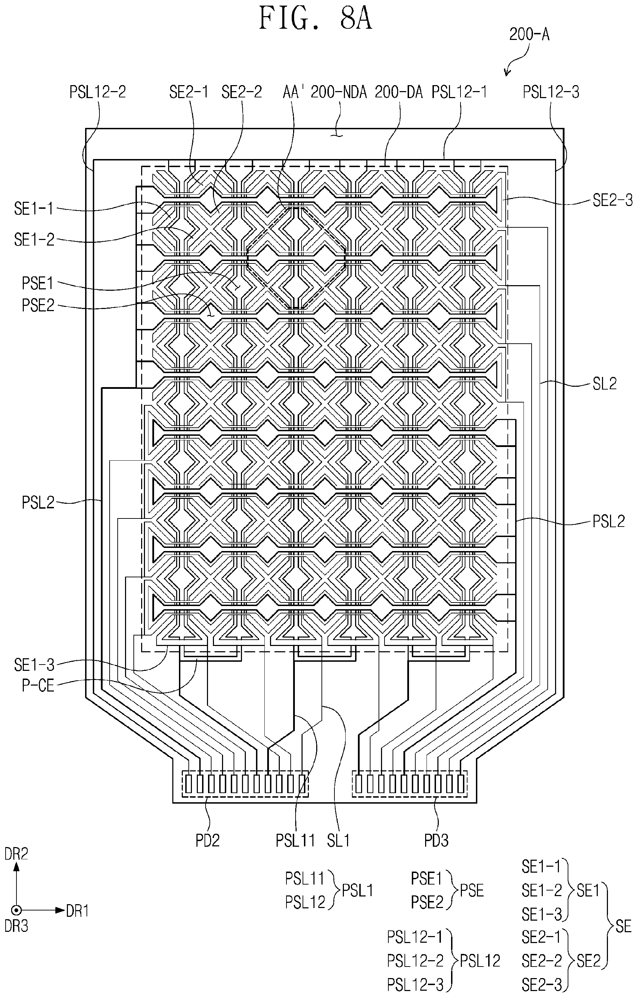

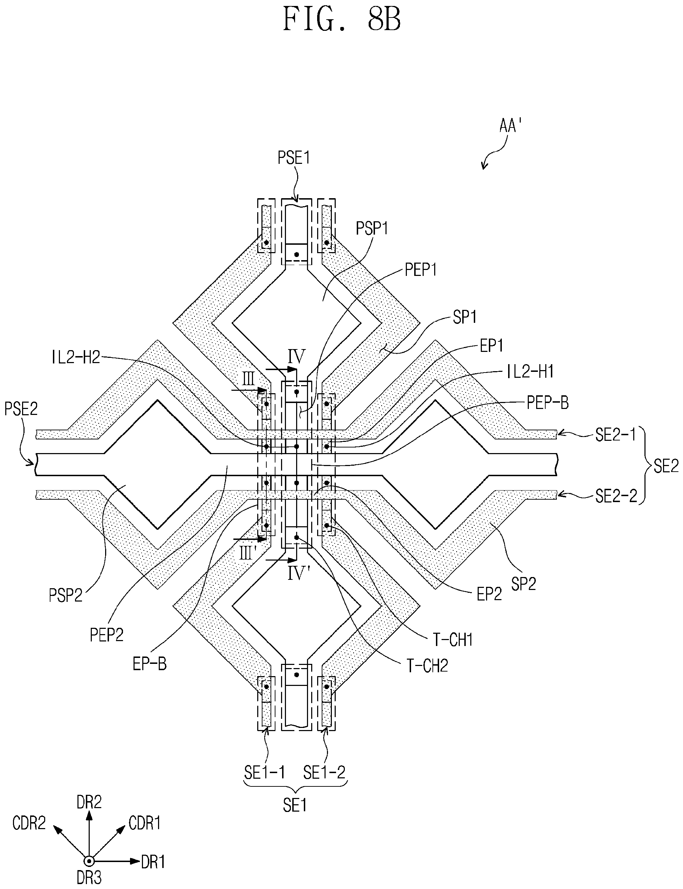

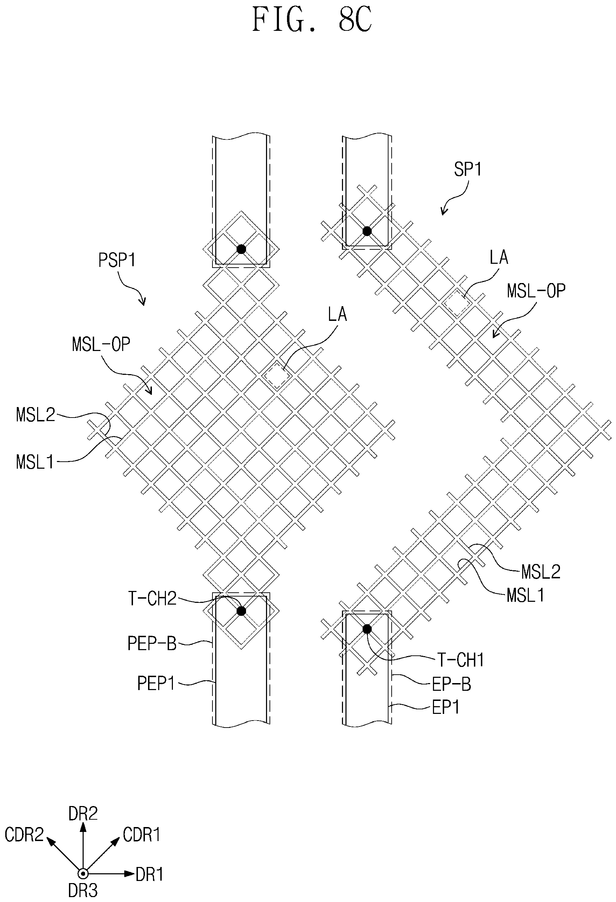

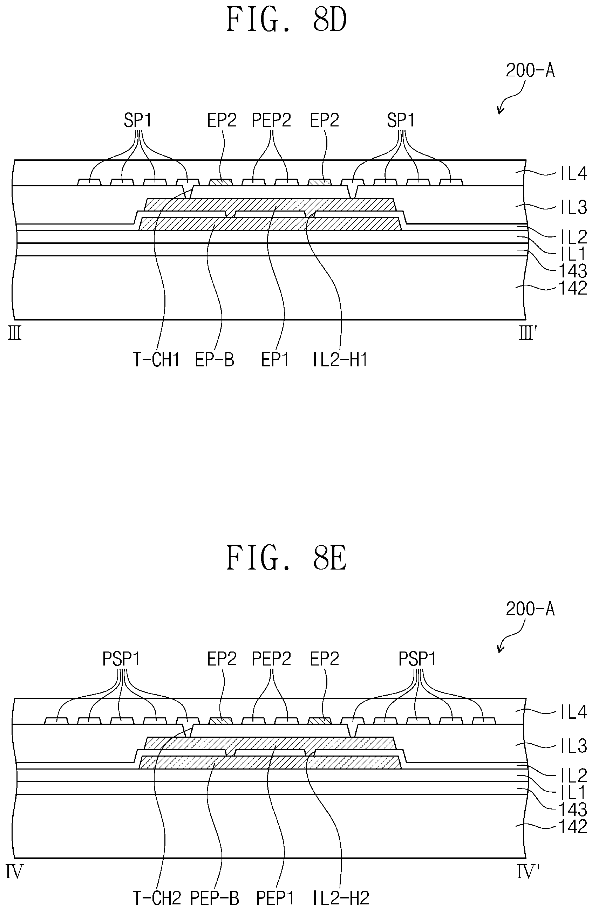

FIG. 8A is a plan view of an input sensor 200-A according to some embodiments of the present disclosure. FIG. 8B is an enlarged plan view of area AA' illustrated in FIG. 8A. FIG. 8C is an enlarged plan view illustrating a part of detection electrodes illustrated in FIG. 8A. FIG. 8D is a sectional view of the input sensor 200-A corresponding to line III-III' illustrated in FIG. 8B. FIG. 8E is a sectional view of the input sensor 200-A corresponding to line IV-IV' illustrated in FIG. 8B.

Referring to FIG. 8A, the input sensor 200-A according to some embodiments may sense a first input using a capacitance method and may sense a second input using an electromagnetic induction method. The first input may be an input by the user's body FG described with reference to FIG. 1A, and the second input may be an input by the stylus pen STP described with reference to FIG. 1A. In other words, the first input may be an input capable of causing a change in capacitance, and the second input may be an input that provides a magnetic field signal.

The input sensor 200-A may sense the first input and the second input through time division driving. A period in which the input sensor 200-A operates in a first mode to sense the first input may be defined as a first operation period, and a period in which the input sensor 200-A operates in a second mode to sense the second input may be defined as a second operation period.

The input sensor 200-A may be switched between the first mode and the second mode through selection by the user. Alternatively, by activation of a specific application, one of the first mode and the second mode may be activated, or the input sensor 200 may be switched between the first mode and the second mode. The input sensor 200-A may be maintained in the first mode when the first input is sensed while the input sensor 200-A alternately operates in the first mode and the second mode, or may be maintained in the second mode when the second input is sensed while the input sensor 200-A alternately operates in the first mode and the second mode.

The input sensor 200-A may include a first group of electrodes SE for sensing the first input and a second group of electrodes PSE for sensing the second input. Although six second-first detection electrodes PSE1 and eight second-second detection electrodes PSE2 included in the second group of electrodes PSE are illustrated in FIG. 8A as an example, the input sensor 200-A may include more detection electrodes.

The first group of electrodes SE may be arranged in the first direction DR1, and each of the first group of electrodes SE may extend in the second direction DR2. Each of the first group of electrodes SE may include a first-first detection electrode SE1 and a first-second detection electrode SE2. The first-first detection electrodes SE1 and the first-second detection electrodes SE2 are capacitively coupled.

A driving circuit of the input sensor 200-A provides a driving signal to one of the first-first detection electrodes SE1 and the first-second detection electrodes SE2, and a sensing circuit of the input sensor 200-A measures a change in the capacitance of a mutual capacitor formed between the first-first detection electrodes SE1 and the first-second detection electrodes SE2 through the other one of the first-first detection electrodes SE1 and the first-second detection electrodes SE2. After the above-described operation is executed during a first section of the first operation period, the above-described operation may be executed in reverse during a second section of the first operation period. The first section and the second section may be repeated as one set.

The second group of electrodes PSE may include the second-first detection electrodes PSE1 and the second-second detection electrodes PSE2 crossing the second-first detection electrodes PSE1. A resonance circuit of the stylus pen STP (refer to FIG. 1A) is charged through at least one of the second-first detection electrodes PSE1 and the second-second detection electrodes PSE2, and a magnetic field signal output from the stylus pen STP (refer to FIG. 1A) is sensed through the second-first detection electrodes PSE1 and the second-second detection electrodes PSE2.

The driving circuit of the input sensor 200-A provides a driving signal to at least one of the second-first detection electrodes PSE1 and the second-second detection electrodes PSE2, and the sensing circuit of the input sensor 200-A senses an electromagnetically induced current formed in the second-first detection electrodes PSE1 and the second-second detection electrodes PSE2.

Each of the first group of electrodes SE may include the first-first detection electrode SE1 and the first-second detection electrode SE2.

The first-first detection electrode SE1 may extend in the second direction DR2. The first-first detection electrode SE1 may include a first-first sensing electrode SE1-1 and a first-second sensing electrode SE1-2 that extend in the second direction DR2 and that are spaced apart from each other with a first space therebetween in the first direction DR1. A first-third sensing electrode SE1-3 may be located at one end of the first-first sensing electrode SE1-1 and one end of the first-second sensing electrode SE1-2 and may connect the first-first sensing electrode SE1-1 and the first-second sensing electrode SE1-2.

As illustrated in FIG. 8B, each of the first-first sensing electrode SE1-1 and the first-second sensing electrode SE1-2 may include first-first sensing patterns SP1 arranged in the second direction DR2 so as to be spaced apart from one another and first-first bridge patterns EP1 (first upper bridge patterns), each of which is located between first-first sensing patterns SP1 adjacent to each other in the second direction DR2.

The first-second detection electrode SE2 may extend in the first direction DR1. The first-second detection electrode SE2 may include a second-first sensing electrode SE2-1 and a second-second sensing electrode SE2-2 that extend in the first direction DR1 and that are spaced apart from each other with a second space therebetween in the second direction DR2. A second-third sensing electrode SE2-3 may be located at one end of the second-first sensing electrode SE2-1 and one end of the second-second sensing electrode SE2-2 and may connect the second-first sensing electrode SE2-1 and the second-second sensing electrode SE2-2.

As illustrated in FIG. 8B, each of the second-first sensing electrode SE2-1 and the second-second sensing electrode SE2-2 may include first-second sensing patterns SP2 arranged in the first direction DR1 so as to be spaced apart from one another and first-second bridge patterns EP2, each of which is located between first-second sensing patterns SP2 adjacent to each other in the first direction DR1. The first-second sensing patterns SP2 and the first-second bridge patterns EP2 may form an integrated pattern, but are distinguished from each other for convenience of description. According to some embodiments, the first-second bridge patterns SP2 may overlap the first-first bridge patterns EP1 (the first upper bridge patterns) when viewed from above the plane (or in a plan view).

Each of the second group of electrodes PSE may include the second-first detection electrode PSE1 and the second-second detection electrode PSE2.

The second-first detection electrode PSE1 may be located in the first space and may extend in the second direction DR2. The second-first detection electrode PSE1 may include second-first sensing patterns PSP1 arranged in the second direction DR2 so as to be spaced apart from one another and second-first bridge patterns PEP1, each of which is located between second-first sensing patterns PSP1 adjacent to each other in the second direction DR2.

According to some embodiments, each of the second-first sensing patterns PSP1 may have a rhombic shape that extends in the first diagonal direction CDR1 and the second diagonal direction CDR2. To correspond to the second-first sensing patterns PSP1, the first-first sensing patterns SP1 included in the first-first sensing electrode SE1-1 may have the shape of "<", and the first-first sensing patterns SP1 included in the first-second sensing electrode SE1-2 may have the shape of ">".

The second-second detection electrode PSE2 may be located in the second space and may extend in the first direction DR1. The second-second detection electrode PSE2 may include second-second sensing patterns PSP2 arranged in the first direction DR1 so as to be spaced apart from one another and second-second bridge patterns PEP2, each of which is located between second-second sensing patterns PSP2 adjacent to each other in the first direction DR1. The second-second sensing patterns PSP2 and the second-second bridge patterns PEP2 may form an integrated pattern, but are distinguished from each other for convenience of description.

According to some embodiments, each of the second-second sensing patterns PSP2 may have a rhombic shape that extends in the first diagonal direction CDR1 and the second diagonal direction CDR2. To correspond to the second-second sensing patterns PSP2, the first-second sensing patterns SP2 included in the second-first sensing electrode SE2-1 may have the shape of "∧", and the first-second sensing patterns SP2 included in the second-second sensing electrode SE2-2 may have the shape of "v".

According to some embodiments, two second-first detection electrodes PSE1 adjacent to each other in the first direction DR1 may be connected through a connecting portion P-CE.

Referring to FIG. 8A, the input sensor 200-A may include first-first sensing lines SL1 connected to first ends of the first-first detection electrodes SE1, first-second sensing lines SL2 connected to first ends of the first-second detection electrodes SE2, second-first sensing lines PSL1 connected to the second-first detection electrodes PSE1, and second-second sensing lines PSL2 connected to first ends of the second-second detection electrodes PSE2. The second-first sensing lines PSL1 may include second-first lines PSL11 connected to first ends of the second-first detection electrodes PSE1 and a second-second line PSL12 connected to second ends of the second-first detection electrodes PSE1. The sensing lines SL1, SL2, PSL1, and PSL2 may be located in a non-sensing area 200-NDA.

The input sensor 200-A may include second pads PD2 and third pads PD3. The second pads PD2 and the third pads PD3 may be located in areas spaced apart from each other in the first direction DR1. The first-first sensing lines SL1, the first-second sensing lines SL2, the second-first sensing lines PSL1, and the second-second sensing lines PSL2 may each be connected to at least one corresponding pad among the second pads PD2 and the third pads PD3. The second pads PD2 and the third pads PD3 may be adjacent to the lower end of the input sensor 200-A when viewed from above the plane (or in a plan view). The first pads PD1 illustrated in FIG. 5 may be located between the second pads PD2 and the third pads PD3 when viewed from above the plane (or in a plan view).

The input sensor 200-A may be divided into a left area and a right area with respect to the center of the input sensor 200-A in the first direction DR1. The second pads PD2 are located in the left area, and the third pads PD3 are located in the right area. The first-first sensing lines SL1 connected to the first-first detection electrodes SE1 located in the left area may be connected to the second pads PD2. The first-first sensing lines SL1 connected to the first-first detection electrodes SE1 located in the right area may be connected to the third pads PD3.

The input sensor 200-A may be divided into an upper area and a lower area with respect to the center of the input sensor 200-A in the second direction DR2. Some of the second-second sensing lines PSL2 are connected to left ends of the second-second detection electrodes PSE2 located in the upper area. The some of the second-second sensing lines PSL2 are connected to the second pads PD2. The other second-second sensing lines PSL2 are connected to right ends of the second-second detection electrodes PSE2 located in the lower area. The other second-second sensing lines PSL2 are connected to the third pads PD3.

The second-second line PSL12 may include a first portion PSL12-1 connected to the ends of the second-first detection electrodes PSE1 located in the upper area, a second portion PSL12-2 that is bent from the first portion PSL12-1 to the left area and that has an end connected to the second pad PD2, and a third portion PSL12-3 that is bent from the first portion PSL12-1 to the right area and that has an end connected to the third pad PD3.

FIG. 8C is an enlarged view of the first-first sensing pattern SP1 included in the first-second sensing electrode SE1-2 and the second-first sensing pattern PSP1 included in the second-first detection electrode PSE1. The first-first sensing pattern SP1 and the second-first sensing pattern PSP1 are illustrated on behalf of the third conductive pattern layer CL3 described with reference to FIG. 6 and may be commonly applied to conductive patterns included in the third conductive pattern layer CL3.

The third conductive pattern layer CL3 described with reference to FIG. 6 may include mesh lines MSL. Accordingly, the first-first sensing pattern SP1 and the second-first sensing pattern PSP1 may include the mesh lines MSL. The mesh lines MSL may include first mesh lines MSL1 extending in the first diagonal direction CDR1 and second mesh lines MSL2 extending in the second diagonal direction CDR2.

The mesh lines MSL1 and MSL2 do not overlap the emissive area LA described with reference to FIG. 6 and overlap the non-emissive area NLA. That is, the mesh lines MSL1 and MSL2 may overlap the pixel defining layer PDL described with reference to FIG. 6. The mesh lines MSL1 and MSL2 define a plurality of mesh openings MSL-OP. The plurality of mesh openings MSL-OP may correspond to the pixel areas PXA (refer to FIG. 6) provided for the respective pixels PX (refer to FIG. 6) in a one-to-one manner. The line widths of the mesh lines MSL1 and MSL2 may range from several nanometers to several micrometers.

Referring to FIGS. 8B to 8E, according to some embodiments, the third conductive pattern layer CL3 may include the first-first sensing patterns SP1 included in the first-first sensing electrode SE1-1 and the first-second sensing electrode SE1-2, the first-third sensing electrode SE1-3, the second-first sensing electrode SE2-1, the second-second sensing electrode SE2-2, the second-third sensing electrode SE2-3, the second-first sensing patterns PSP1 of the second-first detection electrode PSE1, and the second-second detection electrode PSE2.

The second conductive pattern layer CL2 may include the first-first bridge patterns EP1 included in the first-first sensing electrode SE1-1 and the first-second sensing electrode SE1-2 and the second-first bridge patterns PEP1 of the second-first detection electrode PSE1.

The first sensing patterns SP1 may be connected with the first-first bridge patterns EP1 through first contact holes T-CH1 defined in the third sensing insulation layer IL3. The second-first sensing patterns PSP1 may be connected with the second-first bridge patterns PEP1 through second contact holes T-CH2 defined in the third sensing insulation layer IL3.

According to some embodiments, the first conductive pattern layer CL1 may further include first lower bridge patterns EP-B and second lower bridge patterns PEP-B. The first lower bridge patterns EP-B may overlap the first-first bridge patterns EP1 (the first upper bridge patterns). The first-first bridge patterns EP1 may be connected with the first lower bridge patterns EP-B through third contact holes IL2-H1 defined in the second sensing insulation layer IL2. According to some embodiments, the first lower bridge patterns EP-B may have the same shape as the first-first bridge patterns EP1 when viewed from above the plane (or in a plan view) and may receive the same voltage as the first-first bridge patterns EP1.

The second lower bridge patterns PEP-B may overlap the second-first bridge patterns PEP1 (the second lower bridge patterns). The second-first bridge patterns PEP1 may be connected with the second lower bridge patterns PEP-B through fourth contact holes IL2-H2 defined in the second sensing insulation layer IL2. According to some embodiments, the second lower bridge patterns PEP-B may have the same shape as the second-first bridge patterns PEP1 when viewed from above the plane (or in a plan view) and may receive the same voltage as the second-first bridge patterns PEP1.

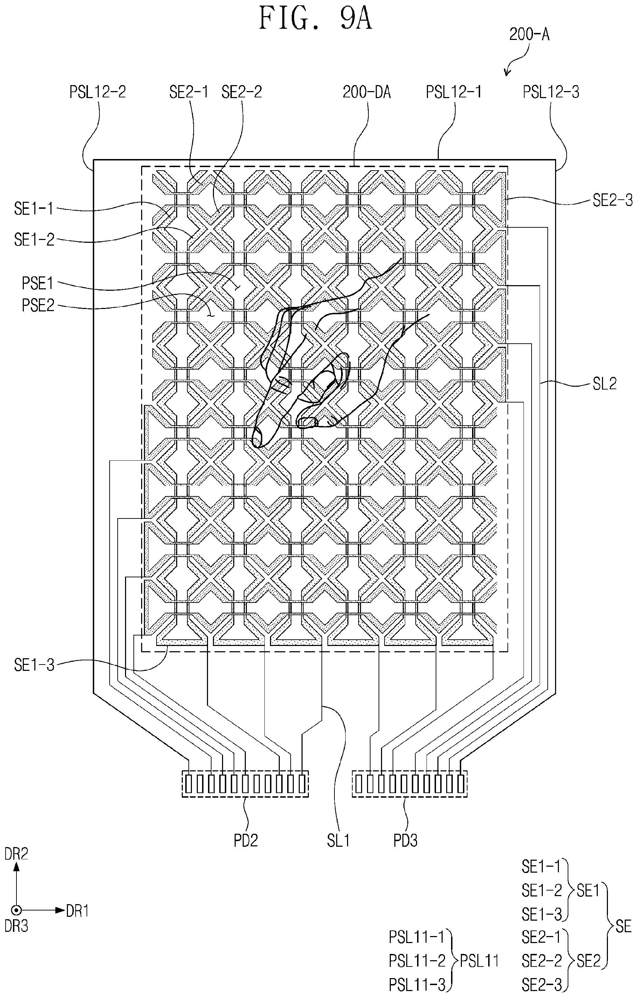

FIGS. 9A to 9E are plan views illustrating operation periods of the detection electrodes of FIG. 8A.

FIG. 9A is a plan view illustrating an operation period of the first group of electrodes SE of FIG. 8A. During the first operation period, the second group of electrodes PSE of FIG. 8A are not involved in an operation of the input sensor 200-A. That is, the input sensor 200-A does not provide a driving signal to the second group of electrodes PSE and does not sense a signal from the second group of electrodes PSE. For simplicity of illustration, the second group of electrodes PSE of FIG. 8A are not illustrated in FIG. 9A.

During the first operation period, the driving circuit of the input sensor 200-A provides driving signals to the first-first detection electrodes SE1 or the first-second detection electrodes SE2. That is, the driving circuit of the input sensor 200-A scans the first-first detection electrodes SE1 or the first-second detection electrodes SE2. For example, the driving circuit of the input sensor 200-A sequentially provides the driving signals to the first-first detection electrodes SE1. Activation periods of the driving signals applied to the first-first detection electrodes SE1 may be different from one another. The driving signals may include a plurality of pulse waves or a plurality of sine waves within the activation periods. The driving circuit of the input sensor 200-A may be embedded in a separate driver IC of the input sensor 200-A, or may be embedded in the driver IC DIC (refer to FIG. 2) mounted on the display panel 100 (refer to FIG. 5).

Current paths proceeding from the electrodes receiving the driving signals among the first-first detection electrodes SE1 to the first-second detection electrodes SE2 are formed. The current paths pass through the mutual capacitor formed between the first-first detection electrodes SE1 and the first-second detection electrodes SE2. A change in the capacitance of the mutual capacitor is detected through the first-second detection electrodes SE2. The sensing circuit of the input sensor 200-A measures electric currents through the first-second detection electrodes SE2 and calculates the capacitance change based on the measured electric currents. For example, the electric current measured through the electrode where an input by the user's body FG (refer to FIG. 1A) occurs among the first-second detection electrodes SE2 is different from the electric currents measured through the other electrodes. The sensing circuit of the input sensor 200-A may be embedded in a separate driver IC of the input sensor 200-A, or may be embedded in the driver IC DIC (refer to FIG. 2) mounted on the display panel 100 (refer to FIG. 5).

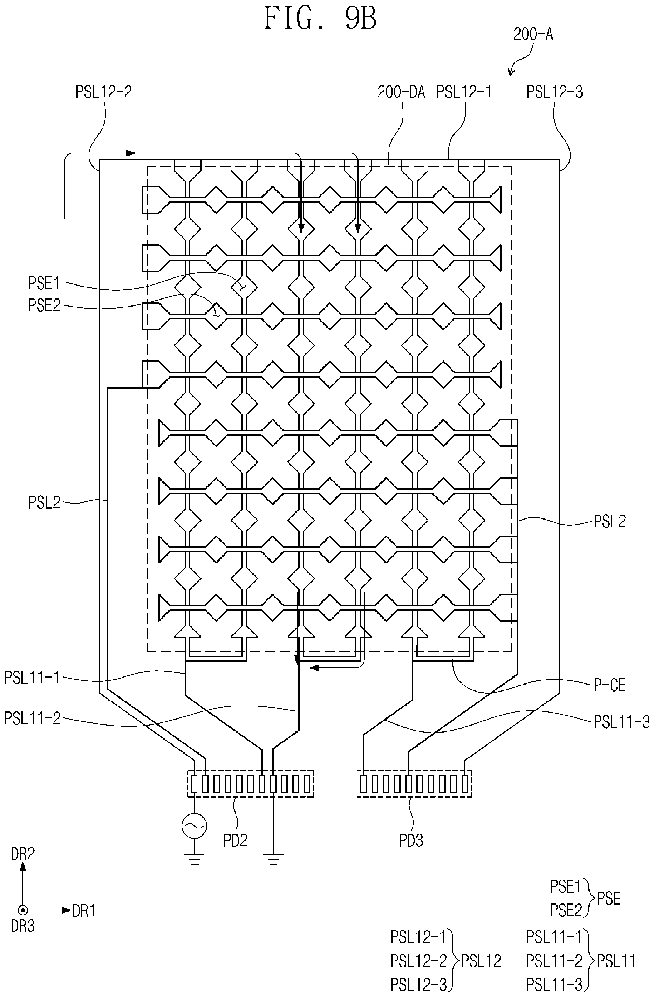

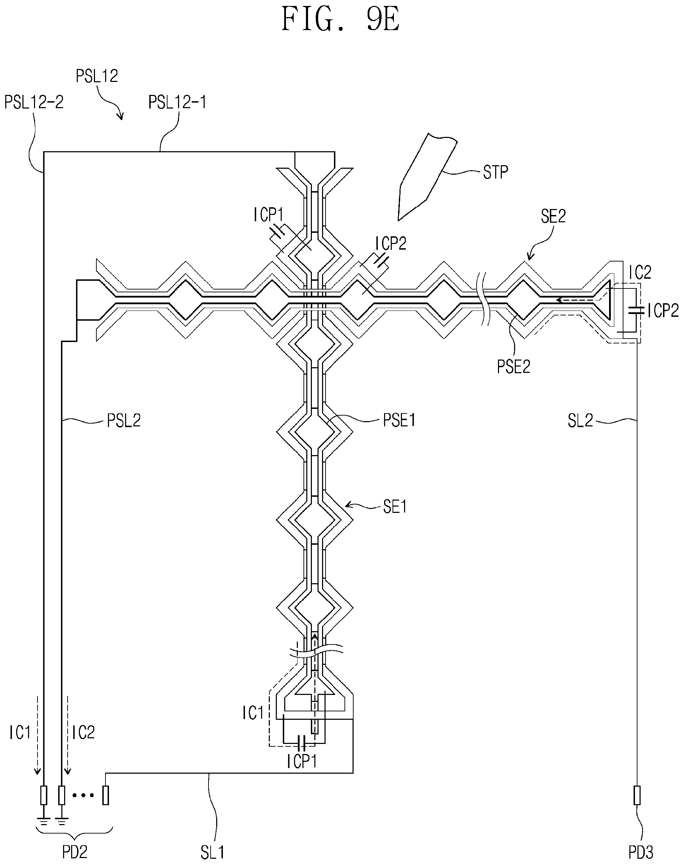

FIGS. 9B to 9D are plan views illustrating a charging period of an operation period of the second group of electrodes PSE of FIG. 8A. FIG. 9E is a plan view illustrating a sensing period of the operation period of the second group of electrodes PSE.

During the charging period of the second operation period, the first group of electrodes SE of FIG. 8A are not involved in an operation of the input sensor 200-A. That is, driving signals are not provided to the first group of electrodes SE. For simplicity of illustration, the first group of electrodes SE of FIG. 8A are not illustrated in FIGS. 9B to 9E. In FIGS. 9B to 9D, for convenience of description, among three second-first lines PSL11, the left second-first line PSL11 is defined as a first signal line PSL11-1, the middle second-first line PSL11 is defined as a second signal line PSL11-2, and the right second-first line PSL11 is defined as a third signal line PSL11-3.

During the charging period, the second-second line PSL12 may receive a driving signal or a ground voltage from at least one of the second pads PD2 or the third pads PD3. A part of the first signal line PSL11-1, the second signal line PSL11-2, and the third signal line PSL11-3 may be selected, and the rest may not be selected. The selected signal line may receive the driving signal or the ground voltage. The second-first detection electrodes PSE1 connected with the selected signal line may also receive the driving signal or the ground voltage. The unselected signal lines may be floated. Some of the second-second line PSL12, the second-first detection electrodes PSE1, and the second-first lines PSL11 may be selected such that a current path is formed in a coil (or, a coil is defined).

Referring to FIG. 9B, during a first section of the charging period, the driving circuit of the input sensor 200-A may select the second pad PD2 connected to the second-second line PSL12 and the second pad PD2 to which the second signal line PSL11-2 is connected. The driving circuit of the input sensor 200-A applies a driving signal to the second pad PD2 connected to the second-second line PSL12 and applies a ground voltage to the second pad PD2 connected to the second signal line PSL11-2. At this time, the first signal line PSL11-1 and the third signal line PSL11-3 may be floated.

The second-second line PSL12, the second-first detection electrode PSE1 located in the center among the second-first detection electrodes PSE1, and the second signal line PSL11-2 define a current path having a coil shape. The coil-shaped current path may generate a magnetic field.

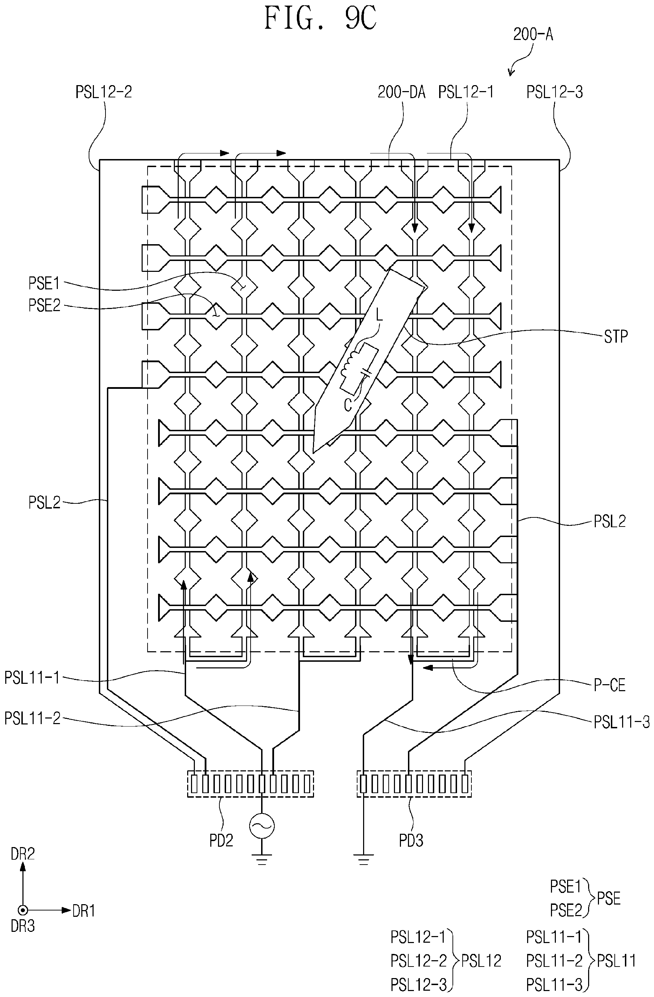

Referring to FIG. 9C, during a second section of the charging period, the driving circuit of the input sensor 200-A may select the second pad PD2 connected to the first signal line PSL11-1 and the third pad PD3 to which the third signal line PSL11-3 is connected. The driving circuit of the input sensor 200-A applies a driving signal to the second pad PD2 connected to the first signal line PSL11-1 and applies a ground voltage to the third pad PD3 connected to the third signal line PSL11-3. The first signal line PSL11-1, the second-first detection electrode PSE1 located on the left side among the second-first detection electrodes PSE1, the second-second line PSL12, the second-first detection electrode PSE1 located on the right side among the second-first detection electrodes PSE1, and the third signal line PSL11-3 define a current path having a coil shape.

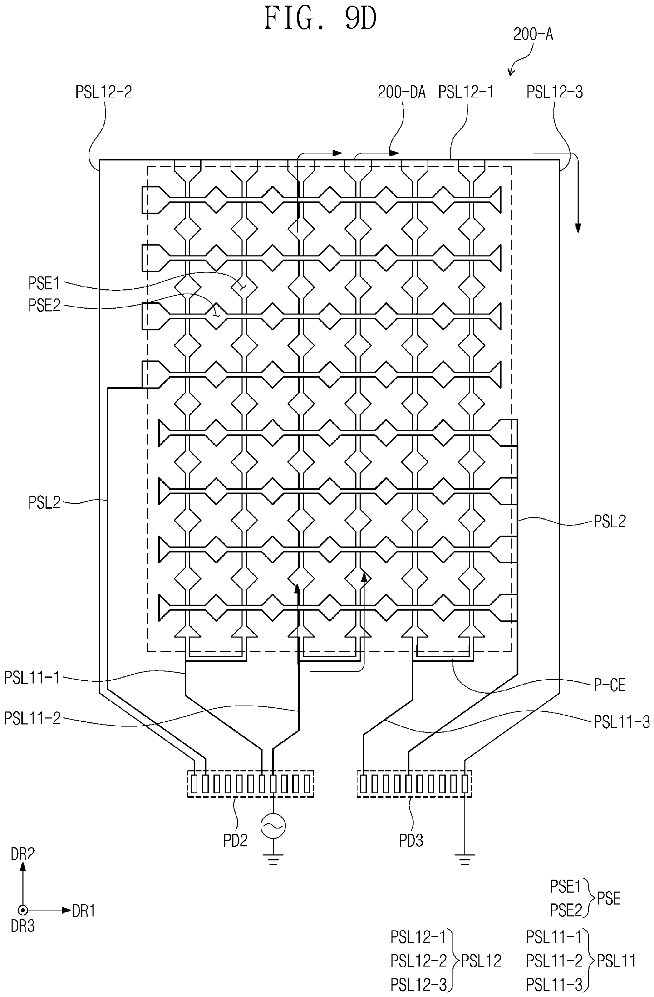

Referring to FIG. 9D, during a third section of the charging period, the driving circuit of the input sensor 200-A may select the second pad PD2 connected to the second signal line PSL11-2 and the third pad PD3 to which the second-second line PSL12 is connected. The driving circuit of the input sensor 200-A applies a driving signal to the second pad PD2 connected to the second signal line PSL11-2 and applies a ground voltage to the third pad PD3 connected to the second-second line PSL12. The second signal line PSL11-2, the second-first detection electrode PSE1 located in the center among the second-first detection electrodes PSE1, and the second-second line PSL12 define a current path having a coil shape.

During the charging period described with reference to FIGS. 9B to 9D, a constant voltage may be applied to the second-first detection electrodes PSE1 through the second-second sensing lines PSL2. The driving sequence of the charging period described with reference to FIGS. 9B to 9D is only an example, and embodiments according to the present disclosure are not limited thereto. The operating sequence of the first to third sections may be changed. In addition, two second-first detection electrodes PSE1 closest to each other among the second-first detection electrodes PSE1 may define a portion of a coil-shaped current path.

Referring to FIG. 9C, the resonance circuit of the stylus pen STP may be charged during the second section of the charging period. The resonance circuit of the stylus pen STP located on the second-first detection electrode PSE1 located in the center receives a magnetic field formed in the current path described with reference to FIG. 9C. The resonance circuit of the stylus pen STP resonates using a signal received through a change in the magnetic field in the current path described with reference to FIG. 9C. The resonance circuit of the stylus pen STP may include an inductor L and a capacitor C connected to the inductor L. An LC resonance circuit may be formed by the inductor L and the capacitor C. The capacitor C may be a variable capacitor whose capacitance is varied.

FIG. 9E illustrates the sensing period of the second operation period. In FIG. 9E, one first-first detection electrode SE1 and one second-first detection electrode PSE1 in which an induced current is generated by a magnetic field signal output from the stylus pen STP are illustrated. An induced current is generated in one first-second detection electrode SE2 and one second-second detection electrode PSE2 illustrated in FIG. 9E by the magnetic field signal output from the stylus pen STP.

Referring to FIGS. 8A and 9E, during the sensing period after the charging period, the sensing circuit of the input sensor 200-A may ground the second-second line PSL12 and may ground the second-second sensing line PSL2. Referring to FIG. 9E, a ground voltage is applied to the second pad PD2 connected to the second-second line PSL12, and a ground voltage is applied to the second pad PD2 connected to the second-second sensing line PSL2 located in the left area. The resonance circuit of the stylus pen STP generates a magnetic field while being discharged. An induced current may be generated in the input sensor 200-A, which is inductively coupled with the resonance circuit of the stylus pen STP, by the magnetic field emitted from the stylus pen STP.

A first capacitor ICP1 is defined between the first-first detection electrode SE1 and the second-first detection electrode PSE1, and a second capacitor ICP2 is defined between the first-second detection electrode SE2 and the second-second detection electrode PSE2.

As the second-second line PSL12 is grounded, a first induced current IC1 flows from the first-first detection electrode SE1 to the second-first detection electrode PSE1 through the first capacitor ICP1. In addition, as the second-second sensing line PSL2 is grounded, a second induced current IC2 flows from the first-second detection electrode SE2 to the second-second detection electrode PSE2 through the second capacitor ICP2. The sensing circuit of the input sensor 200-A may identify an input by the stylus pen STP by sensing the first induced current IC1 through the first-first sensing line SL1 and the second pad PD2 connected thereto and sensing the second induced current IC2 through the first-second sensing line SL2 and the third pad PD3 connected thereto.

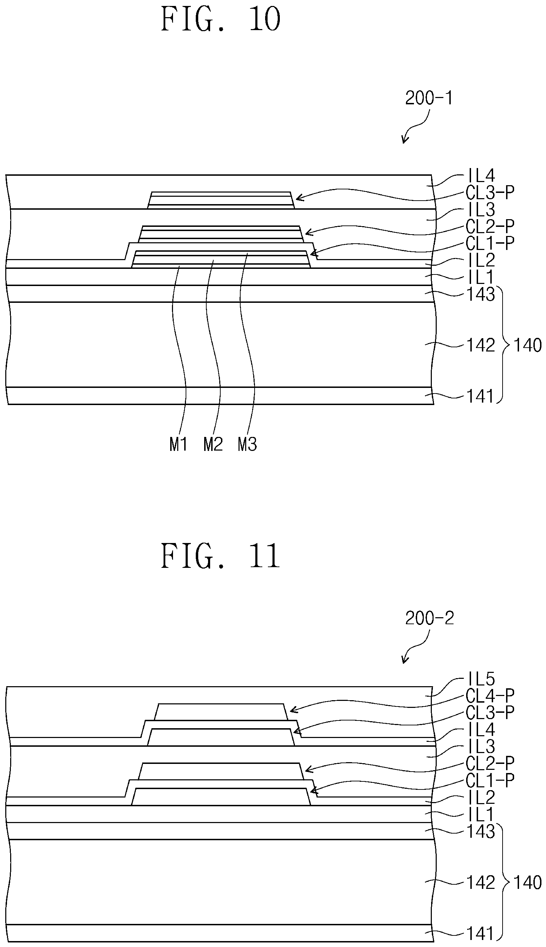

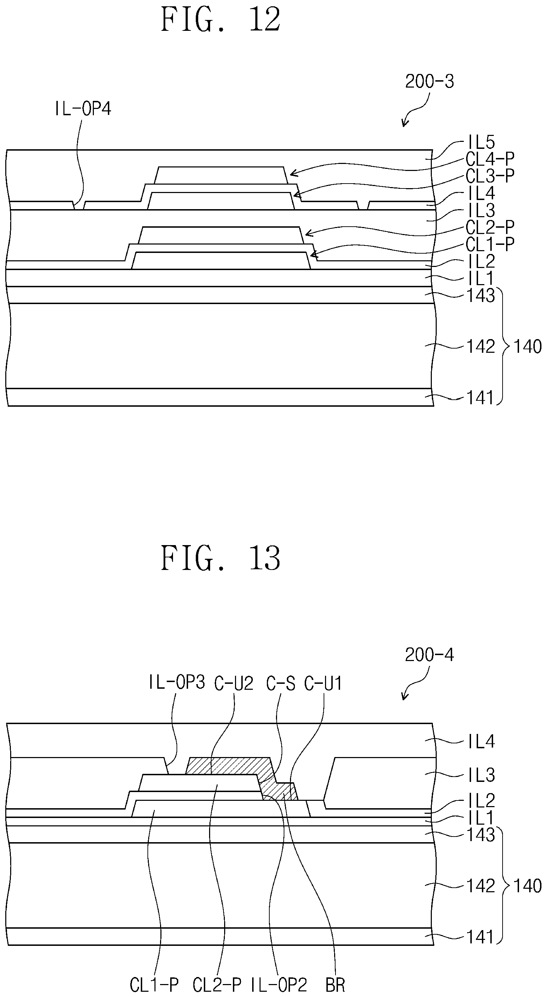

FIG. 10 is a sectional view of an input sensor 200-1 according to some embodiments of the present disclosure. FIG. 11 is a sectional view of an input sensor 200-2 according to some embodiments of the present disclosure. FIG. 12 is a sectional view of an input sensor 200-3 according to some embodiments of the present disclosure. FIG. 13 is a sectional view of an input sensor 200-4 according to some embodiments of the present disclosure. The embodiments that will be described with reference to FIGS. 10 to 13 may be applied to the input sensor 200 described with reference to FIG. 7A and the input sensor 200-A described with reference to FIG. 8A. Components identical or similar to the components described with reference to FIGS. 1A to 9E will be assigned with identical or similar reference numerals, and repetitive descriptions will be omitted.

The sectional views of the input sensors that will be described with reference to FIGS. 10 to 13 may correspond to the sectional view of the conductive patterns included in the conductive pattern layers CL1, CL2, and CL3 described with reference to FIG. 6.

Referring to FIG. 10, the input sensor 200-1 according to some embodiments may include a first sensing insulation layer IL1 located on an encapsulation layer 140, a first conductive pattern CL1-P located on the first sensing insulation layer IL1, a second sensing insulation layer IL2 that is located on the first sensing insulation layer IL1 and that covers the first conductive pattern CL1-P, a second conductive pattern CL2-P located on the second sensing insulation layer IL2, a third sensing insulation layer IL3 that is located on the second sensing insulation layer IL2 and that covers the second conductive pattern CL2-P, a third conductive pattern CL3-P located on the third sensing insulation layer IL3, and a fourth sensing insulation layer IL4 that is located on the third sensing insulation layer IL3 and that covers the third conductive pattern CL3-P.

According to some embodiments, each of the first to fourth sensing insulation layers IL1, IL2, IL3, and IL4 may include an inorganic layer or an organic layer. For example, the first sensing insulation layer IL1 and the second sensing insulation layer IL2 may include a silicon-based inorganic material. The third sensing insulation layer IL3 and the fourth sensing insulation layer IL4 may include an organic material.

Each of the first to third conductive patterns CL1-P to CL3-P according to some embodiments may include first to third layers M1, M2, and M3 sequentially stacked one above another. The thicknesses of the first and third layers M1 and M3 may be smaller than the thickness of the second layer M2. According to some embodiments, each of the first and third layers M1 and M3 may include titanium (Ti), and the second layer M2 may include aluminum (Al).

Referring to FIG. 10, the input sensor 200-1 according to some embodiments may include the first sensing insulation layer IL1 located on the encapsulation layer 140, the first conductive pattern CL1-P located on the first sensing insulation layer IL1, the second sensing insulation layer IL2 that is located on the first sensing insulation layer IL1 and that covers the first conductive pattern CL1-P, the second conductive pattern CL2-P located on the second sensing insulation layer IL2, the third sensing insulation layer IL3 that is located on the second sensing insulation layer IL2 and that covers the second conductive pattern CL2-P, the third conductive pattern CL3-P located on the third sensing insulation layer IL3, and the fourth sensing insulation layer IL4 that is located on the third sensing insulation layer IL3 and that covers the third conductive pattern CL3-P.

According to some embodiments, each of the first to fourth sensing insulation layers IL1, IL2, IL3, and IL4 may include an inorganic layer or an organic layer. For example, the first sensing insulation layer IL1 and the second sensing insulation layer IL2 may include a silicon-based inorganic material. The third sensing insulation layer IL3 and the fourth sensing insulation layer IL4 may include an organic material.

According to some embodiments, the second conductive pattern CL2-P may have the same shape as the first conductive pattern CL1-P when viewed from above the plane (or in a plan view) and may receive the same voltage as the first conductive pattern CL1-P. In addition, the second conductive pattern CL2-P may be connected with the first conductive pattern CL1-P through a contact hole defined in the second sensing insulation layer IL2.

Each of the first to third conductive patterns CL1-P to CL3-P according to some embodiments may include the first to third layers M1, M2, and M3 sequentially stacked one above another. The thicknesses of the first and third layers M1 and M3 may be smaller than the thickness of the second layer M2. According to some embodiments, each of the first and third layers M1 and M3 may include titanium (Ti), and the second layer M2 may include aluminum (Al).

Referring to FIG. 11, the input sensor 200-2 according to some embodiments may include a first sensing insulation layer IL1 located on an encapsulation layer 140, a first conductive pattern CL1-P located on the first sensing insulation layer IL1, a second sensing insulation layer IL2 that is located on the first sensing insulation layer IL1 and that covers the first conductive pattern CL1-P, a second conductive pattern CL2-P located on the second sensing insulation layer IL2, a third sensing insulation layer IL3 that is located on the second sensing insulation layer IL2 and that covers the second conductive pattern CL2-P, a third conductive pattern CL3-P located on the third sensing insulation layer IL3, a fourth sensing insulation layer IL4 that is located on the third sensing insulation layer IL3 and that covers the third conductive pattern CL3-P, a fourth conductive pattern CL4-P located on the fourth sensing insulation layer IL4, and a fifth sensing insulation layer IL5 that is located on the fourth sensing insulation layer IL4 and the covers the fourth conductive pattern CL4-P.

According to some embodiments, each of the first to fourth sensing insulation layers IL1, IL2, IL3, and IL4 may include an inorganic layer or an organic layer. For example, the first sensing insulation layer IL1, the second sensing insulation layer IL2, and the fourth sensing insulation layer IL4 may include a silicon-based inorganic material. The third sensing insulation layer IL3 and the fifth sensing insulation layer IL5 may include an organic material.

According to some embodiments, the second conductive pattern CL2-P may have the same shape as the first conductive pattern CL1-P when viewed from above the plane (or in a plan view) and may receive the same voltage as the first conductive pattern CL1-P. In addition, the second conductive pattern CL2-P may be connected with the first conductive pattern CL1-P through a contact hole defined in the second sensing insulation layer IL2.

According to some embodiments, the fourth conductive pattern CL4-P may have the same shape as the third conductive pattern CL3-P when viewed from above the plane (or in a plan view) and may receive the same voltage as the third conductive pattern CL3-P. In addition, the fourth conductive pattern CL4-P may be connected with the third conductive pattern CL3-P through a contact hole defined in the fourth sensing insulation layer IL4.

The third conductive pattern CL3-P and the fourth conductive pattern CL4-P according to some embodiments may be formed by conductive patterns that are the same as the conductive patterns included in the third conductive pattern layer CL3 of the input sensor 200 described with reference to FIG. 7A, or may be formed by conductive patterns that are the same as the conductive patterns included in the third conductive pattern layer CL3 of the input sensor 200-A described with reference to FIG. 8A. Accordingly, the third conductive pattern CL3-P and the fourth conductive pattern CL4-P according to some embodiments may be implemented with the mesh lines MSL described with reference to FIGS. 7B and 8C.

Hereinafter, the input sensor 200-3 illustrated in FIG. 12 will be described focusing on the difference from the input sensor 200-2 described with reference to FIG. 11.

Referring to FIG. 12, the input sensor 200-3 according to some embodiments may include a first sensing insulation layer IL1 located on an encapsulation layer 140, a first conductive pattern CL1-P located on the first sensing insulation layer IL1, a second sensing insulation layer IL2 that is located on the first sensing insulation layer IL1 and that covers the first conductive pattern CL1-P, a second conductive pattern CL2-P located on the second sensing insulation layer IL2, a third sensing insulation layer IL3 that is located on the second sensing insulation layer IL2 and that covers the second conductive pattern CL2-P, a third conductive pattern CL3-P located on the third sensing insulation layer IL3, a fourth sensing insulation layer IL4 that is located on the third sensing insulation layer IL3 and that covers the third conductive pattern CL3-P, a fourth conductive pattern CL4-P located on the fourth sensing insulation layer IL4, and a fifth sensing insulation layer IL5 that is located on the fourth sensing insulation layer IL4 and the covers the fourth conductive pattern CL4-P.

According to some embodiments, each of the first to fourth sensing insulation layers IL1, IL2, IL3, and IL4 may include an inorganic layer or an organic layer. For example, the first sensing insulation layer IL1, the second sensing insulation layer IL2, and the fourth sensing insulation layer IL4 may include a silicon-based inorganic material. The third sensing insulation layer IL3 and the fifth sensing insulation layer IL5 may include an organic material.

The fourth sensing insulation layer IL4 according to some embodiments may include dummy contact holes IL-OP4 formed through the fourth sensing insulation layer IL4. The dummy contact holes IL-OP4 according to some embodiments may overlap the pixel defining layer PDL described with reference to FIG. 6. and be spaced apart from the third conductive pattern CL3-P. However, embodiments according to the present disclosure are not limited thereto, and some of the dummy contact holes IL-OP4 may overlap the opening PDL-OP described with reference to FIG. 6.

According to some embodiments, the sum of the areas of the dummy contact holes IL-OP4 may be greater than or equal to 0.1% of the area of the fourth sensing insulation layer IL4.

Because the fourth sensing insulation layer IL4 includes the dummy contact holes IL-OP4 according to some embodiments, out-gassing that occurs when the third sensing insulation layer iL3 including an organic material is formed may be easily discharged to the outside. Accordingly, the input sensor 200-3 with relatively improved reliability may be provided.

The embodiments of the input sensor 200-4 that will be described with reference to FIG. 13 may be applied to the connecting method of the first conductive pattern layer CL1 and the second conductive pattern layer CL2 described with reference to FIGS. 6 to 8E.

The input sensor 200-4 according to some embodiments may further include a connecting pattern BR. A first connecting opening IL-OP2 that exposes a portion of a first conductive pattern CL1-P may be defined in a second sensing insulation layer IL2. A second connecting opening IL-OP3 may be defined in a third sensing insulation layer IL3. The second connecting opening IL-OP3 may expose a portion of a second conductive pattern CL2-P and the portion of the first conductive pattern CL1-P that is exposed from the first connecting opening IL-OP2 and may overlap the first connecting opening IL-OP2.

According to some embodiments, the connecting pattern BR may connect the first conductive pattern CL1-P and the second conductive pattern CL2-P that are insulated from each other by the second sensing insulation layer IL2. In more detail, within the second connecting opening IL-OP2, the connecting pattern BR may make contact with the portion of the second conductive pattern CL2-P exposed from the second connecting opening IL-OP2 and the portion of the first conductive pattern CL1-P exposed from the first connecting opening IL-OP2. In this case, the connecting pattern BR may make contact with an upper surface C-U1 of the first conductive pattern CL1-P and an upper surface C-U2 and a side surface C-S of the second conductive pattern CL2-P.

The connecting pattern BR according to some embodiments may include the same material as the third conductive pattern layer CL3 described with reference to FIG. 6.

According to the embodiments of the present disclosure, by increasing the thicknesses of the detection electrodes located in the sensing area, the input sensor including the detection electrodes with relatively reduced resistance may be provided.

While the present disclosure has been described with reference to embodiments thereof, it will be apparent to those of ordinary skill in the art that various changes and modifications may be made thereto without departing from the spirit and scope of the present disclosure as set forth in the following claims, and their equivalents.

## Claims

1. An electronic device (ED) comprising:
a display panel (100) including pixels and an encapsulation layer (140) covering the pixels; and
an input sensor (200, 200-1, 200-2, 200-3, 200-4, 200-A) on the display panel (100),
wherein the input sensor (200, 200-1, 200-2, 200-3, 200-4, 200-A) includes:
a first sensing insulation layer (IL1) directly on the encapsulation layer (140);
a first conductive pattern layer (CL1) on the first sensing insulation layer (IL1);
a second sensing insulation layer (IL2) on the first sensing insulation layer (IL1) and covering the first conductive pattern layer (CL1);
a second conductive pattern layer (CL2) on the second sensing insulation layer (IL2);
a third sensing insulation layer (IL3) on the second sensing insulation layer (IL2) and covering the second conductive pattern layer (CL2);
a third conductive pattern layer (CL3) on the third sensing insulation layer (IL3); and
a fourth sensing insulation layer (IL4) on the third sensing insulation layer (IL3) and covering the third conductive pattern layer (CL3), and
wherein the first conductive pattern layer (CL1) and the second conductive pattern layer (CL2) receive a same voltage.

2. The electronic device (ED) of claim 1, wherein the first sensing insulation layer (IL1) and the second sensing insulation layer (IL2) include a silicon-based inorganic material, and
wherein the third sensing insulation layer (IL3) and the fourth sensing insulation layer (IL4) include an organic material.

3. The electronic device (ED) of claim 1 or 2, wherein the second conductive pattern layer (CL2) is connected with the first conductive pattern layer (CL1) through contact holes defined in the second sensing insulation layer (IL2).

4. The electronic device (ED) of claims 1 to 3, wherein each of the first conductive pattern layer (CL1), the second conductive pattern layer, and the third conductive pattern layer (CL3) has a thickness in a range of 100 nm to 1000 nm.

5. The electronic device (ED) of claims 1 to 4, wherein the input sensor (200, 200-1, 200-2, 200-3, 200-4, 200-A) includes first sensing patterns (SP1) included in the third conductive pattern layer (CL3) and second detection electrodes (SE2) spaced apart from the first sensing patterns (SP1), and
wherein the second conductive pattern layer (CL2) includes upper bridge patterns (CP1) configured to connect the first sensing patterns (SP1) spaced apart from one another through contact holes defined in the third sensing insulation layer (IL3).

6. The electronic device (ED) of claim 5, wherein the first conductive pattern layer (CL1) includes lower bridge patterns (CP-B) connected with the upper bridge patterns (CP1) through contact holes defined in the second sensing insulation layer (IL2), and
wherein the upper bridge patterns (CP1) and the lower bridge patterns (CP-B) have a same shape in a plan view and/or. wherein the third conductive pattern layer (CL3) is implemented with a plurality of mesh lines (MSL1. MSL2) crossing each other and defining mesh openings (310-OP).

7. The electronic device (ED) of claims 1 to 6, wherein the input sensor (200, 200-1, 200-2, 200-3, 200-4, 200-A) is configured to sense an external input using a capacitance method.

8. The electronic device (ED) of claims 1 to 7, wherein the input sensor (200, 200-1, 200-2, 200-3, 200-4, 200-A) includes a first group of electrodes (SE) configured to sense an external input using a capacitance method and a second group of electrodes (PSE configured to sense an external input using an electromagnetic induction method.

9. The electronic device (ED) of claim 8, wherein the first group of electrodes (SE) include:
a first-first detection electrode (SE1) including a first-first sensing electrode (SE1-1) and a first-second sensing electrode (SE1-2) spaced part from each other with a first space therebetween in a first direction (DR1); and
a first-second detection electrode (SE2) insulated from the first-first detection electrode (SE1), the first-second detection electrode (SE2) including a second-first sensing electrode (SE2-1) and a second-second sensing electrode (SE2-2) spaced apart from each other with a second space therebetween in a second direction (DR2) crossing the first direction and/or.
wherein the second group of electrodes (PSE) include:
a second-first detection electrode (PSE1) in the first space and extending in the second direction (DR2); and
a second-second detection electrode (PSE2) in the second space and extending in the first direction (DR1).

10. The electronic device (ED) of claims 1 to 9, wherein the input sensor (200, 200-1, 200-2, 200-3, 200-4, 200-A) further includes a fourth conductive pattern layer on the fourth sensing insulation layer (IL4) and a fifth sensing insulation layer (IL5) on the fourth sensing insulation layer (IL4) and covering the fourth conductive pattern layer, and
wherein the third conductive pattern layer (CL3) and the fourth conductive pattern layer receive a same voltage.

11. The electronic device (ED) of claim 10, wherein the first sensing insulation layer (IL1), the second sensing insulation layer (IL2), and the fourth sensing insulation layer (IL4) include a silicon-based inorganic material, and
wherein the third sensing insulation layer (IL3) and the fifth sensing insulation layer (IL5) include an organic material.

12. The electronic device (ED) of claim 10, wherein the fourth conductive pattern layer is connected with the third conductive pattern layer (CL3) through contact holes defined in the fourth sensing insulation layer (IL4).

13. The electronic device (ED) of claim 10, wherein dummy contact holes spaced apart from the third conductive pattern layer (CL3) are defined in the fourth sensing insulation layer (IL4), and
wherein a sum of areas of the dummy contact holes is greater than or equal to 0.1% of an area of the fourth sensing insulation layer (IL4).

14. The electronic device (ED) of claims 1 to 13, wherein each of the first conductive pattern layer (CL1), the second conductive pattern layer, and the third conductive pattern layer (CL3) includes a first layer (M1), a second layer (M2), and a third (M3) layer sequentially stacked one above another, and
wherein the first layer (M1) and the third layer (M3) include titanium, and the second layer (M2) includes aluminum.

15. The electronic device (ED) of claims 1 to 14, wherein a first connecting opening (310-OP) is defined in the second sensing insulation layer (IL2) to expose a portion of the first conductive pattern layer (CL1), and a second connecting opening (310-OP) is defined in the third sensing insulation layer (IL3) to expose a portion of the second conductive pattern layer (CL2) and the portion of the first conductive pattern layer (CL1) and overlap the first connecting opening (310-OP),
wherein the input sensor (200, 200-1, 200-2, 200-3, 200-4, 200-A) further includes a connecting pattern, and within the second connecting opening (310-OP), the connecting pattern (BR) makes contact with the portion of the second conductive pattern layer (CL2) and the portion of the first conductive pattern layer (CL1), and
wherein the connecting (BR) pattern includes a same material as the third conductive pattern layer (CL3).
